(19) Europäisches Patentamt
European Patent Office
Office européen des brevets

(11) **EP 2 649 642 B1**

(12) **EUROPÄISCHE PATENTSCHRIFT**

(45) Veröffentlichungstag und Bekanntmachung des Hinweises auf die Patenterteilung:
**27.04.2016 Patentblatt 2016/17**

(21) Anmeldenummer: **11791223.8**

(22) Anmeldetag: **03.11.2011**

(51) Int Cl.:
*H01L 21/56* (2006.01)  *H01L 23/31* (2006.01)
*H01L 21/67* (2006.01)  *H01L 51/52* (2006.01)

(86) Internationale Anmeldenummer:
**PCT/EP2011/069301**

(87) Internationale Veröffentlichungsnummer:
**WO 2012/076262 (14.06.2012 Gazette 2012/24)**

(54) **KLEBMASSE UND VERFAHREN ZUR KAPSELUNG EINER ELEKTRONISCHEN ANORDNUNG**

ADHESIVE COMPOUND AND METHOD FOR ENCAPSULATING AN ELECTRONIC ARRANGEMENT

MATIÈRE ADHÉSIVE ET PROCÉDÉ D'ENCAPSULATION D'UN DISPOSITIF ÉLECTRONIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **10.12.2010 DE 102010062823**

(43) Veröffentlichungstag der Anmeldung:
**16.10.2013 Patentblatt 2013/42**

(73) Patentinhaber: **tesa SE**
**22848 Norderstedt (DE)**

(72) Erfinder:
• **KEITE-TELGENBÜSCHER, Klaus**
**22529 Hamburg (DE)**
• **GRÜNAUER, Judith**
**22117 Hamburg (DE)**
• **ELLINGER, Jan**
**20257 Hamburg (DE)**

(56) Entgegenhaltungen:
**EP-A1- 2 166 593**  **WO-A1-2008/142934**
**WO-A1-2010/063579**  **JP-A- 2005 093 963**
**US-A- 5 904 488**  **US-A1- 2006 011 288**
**US-A1- 2009 093 088**

**Beschreibung**

Die vorliegende Erfindung betrifft ein Verfahren für die Kapselung einer elektronischen Anordnung.

(Opto-)elektronische Anordnungen werden immer häufiger in kommerziellen Produkten verwendet oder stehen kurz vor der Markteinführung. Derartige Anordnungen umfassen anorganische oder organische elektronische Strukturen, beispielsweise organische, metallorganische oder polymere Halbleiter oder auch Kombinationen dieser (im Folgenden zusammenfassend organischelektronische Anordnungen genannt). Diese Anordnungen und Produkte sind je nach gewünschter Anwendung starr oder flexibel ausgebildet, wobei eine zunehmende Nachfrage nach flexiblen Anordnungen besteht. Die Herstellung derartiger Anordnungen erfolgt beispielsweise durch Druckverfahren wie Hochdruck, Tiefdruck, Siebdruck, Flachdruck oder wie auch so genanntes "non impact printing" wie etwa Thermotransferdruck Tintenstrahldruck oder Digitaldruck. Vielfach werden aber auch Vakuumverfahren wie zum Beispiel Chemical Vapor Deposition (CVD), Physical Vapor Deposition (PVD), plasmaunterstützte chemische oder physikalische Depositionsverfahren (PECVD), Sputtern, (Plasma-)Ätzen oder Bedampfung verwendet, wobei die Strukturierung in der Regel durch Masken erfolgt.

Im Folgenden werden optoelektronische und organischelektronische Anordnungen gemeinsam als elektronische Anordnungen bezeichnet.

Als Beispiele für bereits kommerzielle oder in ihrem Marktpotential interessante elektronische Anwendungen seien hier elektrophoretische oder elektrochrome Aufbauten oder Displays, organische oder polymere Leuchtdioden (OLEDs oder PLEDs) in Anzeige- und Display-Vorrichtungen oder als Beleuchtung genannt, Elektrolumineszenzlampen, lichtemittierende elektrochemische Zellen (LEECs), organische Solarzellen, bevorzugt Farbstoff- oder Polymersolarzellen, anorganische Solarzellen, bevorzugt Dünnschichtsolarzellen, insbesondere auf der Basis von Silizium, Germanium, Kupfer, Indium und Selen, organische Feldeffekt-Transistoren, organische Schaltelemente, organische optische Verstärker, organische Laserdioden, organische oder anorganische Sensoren oder auch organisch- oder anorganischbasierte RFID-Transponder angeführt.

Als technische Herausforderung für die Realisierung ausreichender Lebensdauer und Funktion von (opto-)elektronischen Anordnungen im Bereich der anorganischen und/oder organischen (Opto-) Elektronik, ganz besonders aber im Bereich der organischen (Opto-)Elektronik sowie der anorganischen Dünnschichtsolarzellen ist ein Schutz der darin enthaltenen Komponenten vor Permeaten zu sehen. Permeate können eine Vielzahl von niedermolekularen organischen oder anorganischen Verbindungen sein, insbesondere Wasserdampf und Sauerstoff.

Unter Permeation versteht man den Vorgang, bei dem ein Stoff (Permeat) einen Festkörper durchdringt oder durchwandert. Die Triebkraft ist ein Konzentrationsgradient. Permeabilität wird durch Permeationsmessung geprüft.

Eine Vielzahl von (opto-)elektronischen Anordnungen im Bereich der anorganischen und/oder organischen (Opto-)Elektronik, ganz besonders bei Verwendung von organischen Rohstoffen, ist sowohl gegen Wasserdampf als auch gegen Sauerstoff empfindlich, wobei für viele Anordnungen das Eindringen von Wasser oder Wasserdampf als größeres Problem eingestuft wird. Während der Lebensdauer der elektronischen Anordnung ist deshalb ein Schutz durch eine Verkapselung erforderlich, da andernfalls die Leistung über den Anwendungszeitraum nachlässt. So können sich beispielsweise durch eine Oxidation der Bestandteile etwa bei lichtemittierenden Anordnungen wie Elektrolumineszenz-Lampen (EL-Lampen) oder organischen Leuchtdioden (OLED) die Leuchtkraft, bei elektrophoretischen Displays (EP-Displays) der Kontrast oder bei Solarzellen die Effizienz innerhalb kürzester Zeit drastisch verringern.

Bei der anorganischen und/oder organischen (Opto-)Elektronik, insbesondere bei der organischen (Opto-)Elektronik, gibt es besonderen Bedarf für flexible Klebelösungen, die eine Permeationsbarriere für Permeate wie Sauerstoff und/oder Wasserdampf darstellen. Daneben gibt es eine Vielzahl von weiteren Anforderungen für derartige (opto)-elektronische Anordnungen. Die flexiblen Klebelösungen sollen daher nicht nur eine gute Haftung zwischen zwei Substraten erzielen, sondern zusätzlich Eigenschaften wie hohe Scherfestigkeit und Schälfestigkeit, chemische Beständigkeit, Alterungsbeständigkeit, hohe Transparenz, einfache Prozessierbarkeit sowie hohe Flexibilität und Biegsamkeit erfüllen.

Ein nach dem Stand der Technik gängiger Ansatz ist deshalb, die elektronische Anordnung zwischen zwei für Wasserdampf und Sauerstoff undurchlässige Substrate zu legen. Anschließend erfolgt dann eine Versiegelung an den Rändern. Für unflexible Aufbauten werden Glas oder Metallsubstrate verwendet, die eine hohe Permeationsbarriere bieten, aber sehr anfällig für mechanische Belastungen sind. Ferner verursachen diese Substrate eine relativ große Dicke der gesamten Anordnung. Im Falle von Metallsubstraten besteht zudem keine Transparenz. Für flexible Anordnungen hingegen kommen Flächensubstrate wie transparente oder nicht transparente Folien zum Einsatz, die mehrlagig ausgeführt sein können. Hierbei können sowohl Kombinationen aus verschieden Polymeren, als auch anorganische oder organische Schichten verwendet werden. Der Einsatz solcher Flächensubstrate ermöglicht einen flexiblen, äußerst dünnen Aufbau. Dabei sind für die verschiedenen Anwendungen unterschiedlichste Substrate wie zum Beispiel Folien, Gewebe, Vliese und Papiere oder Kombinationen daraus möglich.

Um eine möglichst gute Versiegelung zu erzielen, werden spezielle Barriereklebemassen verwendet. Eine gute Klebemasse für die Versiegelung von (opto-)elektronischen Bauteilen weist eine geringe Permeabilität gegen Sauerstoff und insbesondere gegen Wasserdampf auf, hat eine ausreichende Haftung auf der Anordnung und kann gut auf diese auffließen. Eine geringe Haftung auf der Anordnung verringert die Barrierewirkung an der Grenzfläche, wodurch ein Eintritt von Sauerstoff und Wasserdampf unabhängig von den Eigenschaften der Klebmasse ermöglicht wird. Nur wenn der Kontakt zwischen Masse und Substrat durchgängig ist, sind die Masseeigenschaften der bestimmende Faktor für die Barrierewirkung der Klebmasse.

Zur Charakterisierung der Barrierewirkung werden üblicherweise die Sauerstofftransmissionsrate OTR (Oxygen Transmission Rate) sowie die Wasserdampftransmissionsrate WVTR (Water Vapor Transmission Rate) angegeben. Die jeweilige Rate gibt dabei den flächen- und zeitbezogenen Fluss von Sauerstoff beziehungsweise Wasserdampf durch einen Film unter spezifischen Bedingungen von Temperatur und Partialdruck sowie gegebenenfalls weiterer Messbedingungen wie relativer Luftfeuchtigkeit an. Je geringer diese Werte sind, desto besser ist das jeweilige Material zur Kapselung geeignet. Die Angabe der Permeation basiert dabei nicht allein auf den Werten für WVTR oder OTR sondern beinhaltet immer auch eine Angabe zur mittleren Weglänge der Permeation, wie zum Beispiel die Dicke des Materials, oder eine Normalisierung auf eine bestimmte Weglänge.

Die Permeabilität P ist ein Maß für die Durchlässigkeit eines Körpers für Gase und/oder Flüssigkeiten. Ein niedriger P-Wert kennzeichnet eine gute Barrierewirkung. Die Permeabilität P ist ein spezifischer Wert für ein definiertes Material und ein definiertes Permeat unter stationären Bedingungen bei bestimmter Permeationsweglänge, Partialdruck und Temperatur. Die Permeabilität P ist das Produkt aus Diffusions-Term D und Löslichkeits-Term S:

$$P = D * S$$

Der Löslichkeitsterm S beschreibt vorwiegend die Affinität der Barriereklebemasse zum Permeat. Im Fall von Wasserdampf wird beispielsweise ein geringer Wert für S von hydrophoben Materialen erreicht. Der Diffusionsterm D ist ein Maß für die Beweglichkeit des Permeats im Barrierematerial und ist direkt abhängig von Eigenschaften wie der Molekülbeweglichkeit oder dem freien Volumen. Oft werden bei stark vernetzten oder hochkristallinen Materialen für D relativ niedrige Werte erreicht. Hochkristalline Materialien sind jedoch in der Regel weniger transparent und eine stärkere Vernetzung führt zu einer geringeren Flexibilität. Die Permeabilität P steigt üblicherweise mit einer Erhöhung der molekularen Beweglichkeit an, etwa auch wenn die Temperatur erhöht oder der Glasübergangspunkt überschritten wird.

Ansätze, um die Barrierewirkung einer Klebemasse zu erhöhen, müssen die beiden Parameter D und S insbesondere berücksichtigen im Hinblick auf den Einfluss auf die Durchlässigkeit von Wasserdampf und Sauerstoff. Zusätzlich zu diesen chemischen Eigenschaften müssen auch Auswirkungen physikalischer Einflüsse auf die Permeabilität bedacht werden, insbesondere die mittlere Permeationsweglänge und Grenzflächeneigenschaften (Auffließverhalten der Klebmasse, Haftung). Die ideale Barriereklebemasse weist geringe D-Werte und S-Werte bei sehr guter Haftung auf dem Substrat auf.

Ein geringer Löslichkeits-Term S allein ist meist unzureichend, um gute Barriereeigenschaften zu erreichen. Ein klassisches Beispiel dafür sind insbesondere Siloxan-Elastomere. Die Materialien sind äußerst hydrophob (kleiner Löslichkeits-Term), weisen aber durch ihre frei drehbare Si-O Bindung (großer Diffusions-Term) eine vergleichsweise geringe Barrierewirkung gegen Wasserdampf und Sauerstoff auf. Für eine gute Barrierewirkung ist also eine gute Balance zwischen Löslichkeits-Term S und Diffusions-Term D notwendig.

Hierfür wurden bisher vor allem Flüssigklebstoffe und Adhäsive auf Basis von Epoxiden verwendet (WO 98/21287 A1; US 4,051,195 A; US 4,552,604 A). Diese haben durch eine starke Vernetzung einen geringen Diffusionsterm D. Ihr Haupteinsatzgebiet sind Randverklebungen starrer Anordnungen, aber auch mäßig flexible Anordnungen. Eine Aushärtung erfolgt thermisch oder mittels UV-Strahlung. Eine vollflächige Verklebung ist aufgrund des durch die Aushärtung auftretenden Schrumpfes kaum möglich, da es beim Aushärten zu Spannungen zwischen Kleber und Substrat kommt, die wiederum zur Delaminierung führen können.

Der Einsatz dieser flüssigen Klebstoffe birgt eine Reihe von Nachteilen. So können niedermolekulare Bestandteile (VOC - volatile organic compound) die empfindlichen elektronischen Strukturen der Anordnung schädigen und den Umgang in der Produktion erschweren. Der Klebstoff muss aufwändig auf jeden einzelnen Bestandteil der Anordnung aufgebracht werden. Die Anschaffung von teuren Dispensern und Fixiereinrichtungen ist notwendig, um eine genaue Positionierung zu gewährleisten. Die Art der Auftragung verhindert zudem einen schnellen kontinuierlichen Prozess und auch durch den anschließend erforderlichen Laminationsschritt kann durch die geringe Viskosität das Erreichen einer definierten Schichtdicke und Verklebungsbreite in engen Grenzen erschwert sein.

Des Weiteren weisen solche hochvernetzten Klebstoffe nach dem Aushärten nur noch eine geringe Flexibilität auf. Der Einsatz von thermisch-vernetzenden Systemen wird im niedrigen Temperaturbereich oder bei 2-Komponenten-Systemen durch die Topfzeit begrenzt, also die Verarbeitungszeit bis eine Vergelung stattgefunden hat. Im hohen Temperaturbereich und insbesondere bei langen Reaktionszeiten begrenzen wiederum die empfindlichen (opto-)elektronischen Strukturen die Verwendbarkeit derartiger Systeme - die maximal anwendbaren Temperaturen bei (opto-)elektronischen Strukturen liegen manchmal nur bei 60 °C, da bereits ab dieser Temperatur eine Vorschädigung eintreten kann. Insbesondere flexible Anordnungen, die organische Elektronik enthalten und mit transparenten Polymerfolien oder Verbunden aus Polymerfolien und anorganischen Schichten gekapselt sind, setzen hier enge Grenzen. Dies gilt auch für Laminierschritte unter großem Druck. Um eine verbesserte Haltbarkeit zu erreichen, ist hier ein Verzicht auf einen temperaturbelastenden Schritt und eine Laminierung unter geringerem Druck von Vorteil.

Alternativ zu den thermisch härtbaren Flüssigklebstoffen werden mittlerweile vielfach auch strahlenhärtende Klebstoffe eingesetzt (US 2004/0225025 A1). Die Verwendung von strahlenhärtenden Klebstoffen vermeidet eine lange andauernde Wärmebelastung der elektronischen Anordnung. Jedoch kommt es durch die Bestrahlung zu einer kurzfristigen punktuellen Erhitzung der Anordnung, da neben einer UV-Strahlung in der Regel auch ein sehr hoher Anteil an IR-Strahlung emittiert wird. Weitere oben genannte Nachteile von Flüssigklebstoffen wie VOC, Schrumpf, Delamination und geringe Flexibilität bleiben ebenfalls erhalten. Probleme können durch zusätzliche flüchtige Bestandteile oder Spaltprodukte aus den Photoinitiatoren oder Sensitizern entstehen. Zudem muss die Anordnung durchlässig für UV-Licht sein.

Da Bestandteile insbesondere organischer Elektronik und viele der eingesetzten Polymere häufig empfindlich gegen UV-Belastung sind, ist ein länger andauernder Außeneinsatz nicht ohne weitere zusätzliche Schutzmaßnahmen, etwa weitere Deckfolien möglich. Diese können bei UV-härtenden Klebesystemen erst nach der UV-Härtung aufgebracht werden, was die Komplexität der Fertigung und die Dicke der Anordnung zusätzlich erhöht.

Die US 2006/0100299 A1 offenbart ein UV-härtbares Haftklebeband zur Kapselung einer elektronischen Anordnung. Das Haftklebeband umfasst eine Klebemasse auf Basis einer Kombination eines Polymers mit einem Erweichungspunkt von größer 60 °C, eines polymerisierbaren Epoxidharzes mit einem Erweichungspunkt von unter 30 °C und eines Photoinitiators. Bei den Polymeren kann es sich um Polyurethan, Polyisobutylen, Polyacrylnitril, Polyvinylidenchlorid, Poly(meth)acrylat oder Polyester, insbesondere aber um ein Acrylat handeln. Des Weiteren sind Klebharze, Weichmacher oder Füllstoffe enthalten.

Acrylatmassen haben eine sehr gute Beständigkeit gegenüber UV-Strahlung und verschiedenen Chemikalien, besitzen aber sehr unterschiedliche Klebkräfte auf verschiedenen Untergründen. Während die Klebkraft auf polaren Untergründen wie Glas oder Metall sehr hoch ist, ist die Klebkraft auf unpolaren Untergründen wie beispielsweise Polyethylen oder Polypropylen eher gering. Hier besteht die Gefahr der Diffusion an der Grenzfläche in besonderem Maße. Zudem sind diese Massen sehr polar, was eine Diffusion insbesondere von Wasserdampf, trotz nachträglicher Vernetzung, begünstigt. Durch den Einsatz polymerisierbarer Epoxidharze wird diese Tendenz weiter verstärkt.

Die in US 2006/0100299 A1 genannte Ausführung als Haftklebemasse hat den Vorteil einer einfachen Applikation, leidet aber ebenfalls unter möglichen Spaltprodukten durch die enthaltenen Photoinitiatoren, einer zwangsläufigen UV-Durchlässigkeit des Aufbaus und einer Verringerung der Flexibilität nach der Aushärtung. Zudem ist durch den geringen Anteil an Epoxidharzen oder anderen Vernetzern, der für eine Erhaltung der Haftklebrigkeit und insbesondere der Kohäsion notwendig ist, eine nur sehr viel geringere Vernetzungsdichte als mit Flüssigklebern erreichbar.

Haftklebebänder benötigen in der Regel durch die relativ hochmolekularen Polymere im Gegensatz zu Flüssigklebstoffen für eine gute Benetzung und Haftung auf der Oberfläche eine gewisse Zeit, ausreichenden Druck und eine gute Balance zwischen viskosem Anteil und elastischen Anteil.

Die WO 2007/087281 A1 offenbart ein transparentes flexibles Haftklebeband auf Basis von Polyisobutylen (PIB) für elektronische Anwendungen, insbesondere OLED. Dabei wird Polyisobutylen mit einem Molekulargewicht von mehr als 500.000 g/mol und ein hydriertes cyclisches Harz verwendet. Optional ist der Einsatz eines photopolymerisierbaren Harzes und eines Photoinitiators möglich.

Klebemassen auf der Basis von Polyisobutylen weisen aufgrund ihrer geringen Polarität eine gute Barriere gegen Wasserdampf auf, haben aber selbst bei hohen Molekulargewichten eine relativ geringe Kohäsivität, weshalb sie bei erhöhten Temperaturen häufig eine geringe Scherfestigkeit aufweisen. Der Anteil an niedermolekularen Bestandteilen kann nicht beliebig reduziert werden, da sonst die Haftung deutlich verringert wird und die Grenzflächenpermeation zunimmt. Bei Einsatz eines hohen Anteils an funktionellen Harzen, der aufgrund der sehr geringen Kohäsion der Masse notwendig ist, wird die Polarität der Masse wieder erhöht und damit der Löslichkeits-Term vergrößert.

Beschrieben sind weiterhin Barriereklebemassen auf der Basis von Styrolblockcopolymeren, möglichst hydrierten Styrolblockcopolymeren, sowie entsprechend hydrierten Harzen, und zwar in der DE 10 2008 047 964 A1.

Durch die Bildung von zumindest zwei Domänen innerhalb des Blockcopolymers erhält man zusätzlich eine sehr gute Kohäsion bei Raumtemperatur und gleichzeitig verbesserte Barriereeigenschaften.

Aus dem Stand der Technik ist zudem eine Haftklebemasse ohne Barriereeigenschaften bekannt (WO 03/065470 A1), die in einem elektronischen Aufbau als Transferklebemasse verwendet wird. Die Klebemasse enthält einen funktionellen Füllstoff, der mit Sauerstoff oder Wasserdampf innerhalb des Aufbaus reagiert. Damit ist eine einfache Applikation eines Scavengers innerhalb des Aufbaus möglich. Für die Versiegelung des Aufbaus nach außen wird ein weiteres Adhäsiv mit geringer Durchlässigkeit verwendet.

Sowohl die Haftklebmassen auf Basis von Polyisobutylen als auch solche auf Basis von hydrierten Styrolblockcopolymeren zeigen einen bedeutenden Nachteil. Bei einer Verklebung zwischen zwei Folien, die mit einer Barriereschicht versehen sind, zum Beispiel zwei PET-Folien mit einer SiOx-Beschichtung, wie sie zum Beispiel für organische Solarzellen eingesetzt werden kann, kommt es bei einer Lagerung in der Feuchte und Wärme zu einer starken Blasenbildung. Auch ein vorheriges Trocknen der Folien und/oder Klebemasse kann diese Blasenbildung nicht verhindern. Insbesondere nachteilig ist dieses Verhalten bei vollflächig über eine elektronische Anordnung laminierten Haftklebemassen, da neben der mangelnden Permeationsbarriere auch optische Fehler auftreten.

Ebenfalls zum stand der technik gehören EP 2 166593 A1 und US 5 904 488 A.

Aufgabe der vorliegenden Erfindung ist es, ein verbessertes Verfahren zur Kapselung einer elektronischen Anordnung gegen Permeate, insbesondere Wasserdampf und Sauerstoff, anzugeben, das die elektronische Anordnung nicht schädigt, gut in bestehende Fertigungsprozesse integriert werden kann und mit dem gleichzeitig eine gute Kapselung erzielt wird. Ferner soll die Lebensdauer von elektronischen Anordnungen durch die Herstellung einer dichteren Grenzschicht im Verkapselungsverbund erhöht werden sowie die Gefahr von optischen Fehlern insbesondere bei einer die elektronische Anordnung überdeckenden Verklebung vermindert werden.

Gelöst wird diese Aufgabe durch ein Verfahren, wie es im Hauptanspruch niedergelegt ist. Gegenstand der Unteransprüche sind dabei vorteilhafte Ausgestaltungen und Weiterbildungen sowie Vorrichtungen zur Durchführung des erfindungsgemäßen Verfahrens.

Demgemäß betrifft der Hauptanspruch ein Verfahren zur Kapselung einer elektronischen Anordnung gegen Permeate, bei dem eine elektronische Anordnung auf einem Substrat zur Verfügung gestellt wird, wobei im Vakuum die den zu kapselnden Bereich der elektronischen Anordnung umfangende Fläche des Substrats, vorzugsweise diese Fläche und der zu kapselnde Bereich der elektronischen Anordnung, mit einem Flächengebilde umfassend zumindest eine Klebemasse in Kontakt gebracht und ein Verbund, vorzugsweise durch Lamination, hergestellt wird.

Es ist dabei nicht erforderlich, dass sich die gesamte elektronische Anordnung im Vakuum befindet. Es reicht, wenn sie zumindest in dem Bereich partiell im Vakuum ist, in dem der Kontakt und die Lamination tatsächlich stattfinden.

Vorzugsweise ist die Klebmasse eine Haftklebmasse, also eine viskoelastische Masse, die bei Raumtemperatur in trockenem Zustand permanent klebrig und klebfähig bleibt. Die Klebung erfolgt durch leichten Anpressdruck sofort auf fast allen Substraten.

Bei der Klebemasse kann es sich auch um eine (Heiß-)Schmelzklebemasse handeln, also ein bei Raumtemperatur fester, im Wesentlichen wasser- und lösemittelfreier Klebstoff, der mit den zu verklebenden Teilen in der Schmelze in Kontakt gebracht wird und nach dem Zusammenfügen beim Abkühlen unter Verfestigung physikalisch abbindet. Vorzugsweise ist eine (Heiß-)Schmelzklebemasse vollkommen wasser- und lösemittelfrei.

Unter Vakuum wird erfindungsgemäß ein reduzierter Umgebungsdruck von weniger als oder gleich 800 mbar verstanden. Bevorzugt wird ein Druck von weniger als 200 mbar, insbesondere von weniger als 50 mbar eingesetzt, da hierbei eine besonders gute Laminierqualität erreicht werden kann.

Besonders vorteilhaft ist ein Druck zwischen 100 und 200 mbar, da hier ein guter Kompromiss zwischen guter Laminierqualität und technischem Aufwand zur Herstellung und Aufrechterhaltung des Vakuums vorliegt.

Ein erfindungsgemäß "höherer Druckbereich" beispielsweise zwischen 700 und 800 mbar hat den Vorteil, dass der technische Aufwand zur Erzeugung des Unterdrucks gering gehalten werden kann.

In einer weiteren vorteilhaften Ausführung wird das Vakuum durch Erhöhung der geographischen Höhe des Laminationsortes erzeugt. Bevorzugt ist eine Höhe zwischen 3000 und 4000 m ü.NN, da hier ausreichend mit Infrastruktur versehene Produktionsorte zu finden sind und überdies Menschen bequem leben können. Als Beispiel seien hier Städte wie La Paz (Bolivien) und Lhasa (China) genannt.

Überraschend zeigt ein nach dem erfindungsgemäßen Verfahren verkapselter Calciumspiegel, der als Bestandteil eines Testverfahrens die Lebensdauer eines elektronischen Bauelements simuliert, eine höhere Lebensdauer als ein unter hohem Druck - also einem Mehrfachen des Atmosphärendrucks und somit nicht im Vakuum - zusammenlaminierter Verbund. Dabei unterschieden sich die Laminate nicht in ihrer optischen Qualität, bei beiden Aufbauten sind auch unter dem Mikroskop keine Blasen zu erkennen.

Im Unterschied zu bekannten Vakuumlaminationsverfahren, bei denen zunächst der Lagenverbund unter Atmosphärendruck aufgebaut und danach in geschichtetem Zustand in das Vakuum eingebracht wird, erfolgt hier die Vakuumbeaufschlagung bereits vor dem Zusammenführen der Schichten. Dies hat den Vorteil, dass insbesondere bei der Verwendung von Haftklebstoffen auch an den zwangsweise gegebenen Kontaktstellen beim konventionellen Verfahren keine Gasblasen eingeschlossen werden.

Weiterhin vorteilhaft ist das Verfahren in Kombination mit weiteren Vakuumverfahren, die etwa zum Herstellen von elektronischen Aufbauten verwendet werden, zum Beispiel bei der Nutzung von Small Molecules als aktive Schichten oder von aufgedampften Metallen oder Metallverbindungen in solchen Aufbauten. Mit dem erfindungsgemäßen Verfahren kann die Verkapselung solcher Aufbauten direkt im Prozessvakuum vorgenommen werden ohne die Notwendigkeit einer Zwischenbelüftung.

Überraschend wurde festgestellt, dass durch das erfindungsgemäße Verfahren eine Blasenbildung in der Feuchte und Wärme vermieden werden kann, obwohl im Vergleichsbeispiel bei der Lamination unter Atmosphärendruck sowie hohem Laminierdruck (der Laminierdruck war hier erheblich größer als der Atmosphärendruck) eine solche Blasenbildung sehr wohl auftrat, auch wenn unter dem Mikroskop keine Blasen erkennbar waren. Der Effekt des Vakuums kann also überraschend nicht durch erhöhten Laminierdruck ausgeglichen werden.

In einer vorteilhaften Ausführung des Verfahrens wird das Vakuum nicht in einer abgeschlossenen Kammer sondern nur partiell auf der elektronischen Anordnung und/oder dem Substrat hergestellt, zum Beispiel im Zwickel einer Walzenlamination. Hierzu kann zum Beispiel eine sogenannte Vakuumbox (Vakuumschacht) verwendet werden, wie sie in der Flachfolien-Extrusionstechnologie zum Anlegen von extrudierten Folien an die Abkühlwalze verwendet wird (siehe beispielsweise das Buch "Technologie der Extrusion" von Helmut Greif, Carl Hanser Verlag, 2004). Hiermit wird das Vakuum lediglich auf einer Linie erzeugt. Vorteilhaft ist hier der geringe technische Aufwand, um lokal ein Vakuum bereitzustellen. Überraschend wurde festgestellt, dass dieses Vakuum bereits ausreicht, die Verkapselungsqualität zu verbessern und eine Blasenbildung der Klebemassen in der Feuchte und Wärme zu verhindern.

In einer weiteren vorteilhaften Ausführung des Verfahrens wird die Vakuumlamination innerhalb eines Rolle-zu-Rolle-Verfahrens durchgeführt. Dabei wird die elektronische Anordnung auf dem Substrat als bahnförmiges Material zur Verfügung gestellt, welches dann zum Beispiel eine Vielzahl von einzelnen elektronischen Anordnungen beinhalten kann. Auch das haft- oder heißschmelzklebrige Flächengebilde wird vorteilhaft als bahnförmiges Material zur Verfügung gestellt, zum Beispiel als homogenes flächenförmiges Material oder als einzelne Stanzlinge, die auf einem bahnförmigen Trägersubstrat angeordnet sind. Die Vakuumlamination erfolgt dann kontinuierlich. Dies kann zum Beispiel in einer Vakuumkammer erfolgen, innerhalb der Auf- und Abrollungen angeordnet sind oder die mit entsprechenden Schleusen für den Ein- und Auslauf der bahnförmigen Materialien versehen ist. Vorteilhaft ist hierfür aber die partielle Vakuumerzeugung, zum Beispiel mittels einer Vakuumbox. Vorteilhaft an der Nutzung eines Rolle-zu-Rolle-Verfahrens ist die höhere Produktivität und die größere Wirtschaftlichkeit solcher kontinuierlichen Verfahren.

Besonders vorteilhaft ist auch die Verwendung eines Walzenlaminationsprozesses, bei der zumindest eine Walze eine Kraft zur Herstellung des Verbunds aufbringt. Die Gegenkraft kann dann zum Beispiel von einer ebenen Platte, einem Gurtband oder einer weiteren Walze aufgebracht werden. Vorteilhaft an dieser Ausführung ist, dass eventuell noch vorhandene Restgasmengen gezielt in eine Richtung ausgetrieben werden und somit die Qualität des Verbunds verbessert wird.

In einer besonders vorteilhaften Ausführung werden zwei Laminierwalzen verwendet.

Die bevorzugte Laminierkraft entlang der Berührungslinie von Walze und Gegenstück ist abhängig von der verwendeten Klebemasse und beträgt beim Walzenlaminierprozess zwischen 0,5 und 100 N/cm. Insbesondere bei Haftklebemassen ist ein Bereich von 5 bis 50 N/cm bevorzugt, da durch den hohen Druck das Auffließen verbessert wird. Bei Heißschmelzklebemassen ist ein Bereich von 0,5 N/cm bis 2 N/cm bevorzugt, da hierbei die Gefahr des unkontrollierten Masseausfließens verringert ist.

Allgemein ist ein Laminierdruck von 0,01 MPa bis 5 MPa bevorzugt. Bei Haftklebemassen ist ein Bereich von 0,5 MPa bis 5 MPa bevorzugt, da durch den hohen Druck das Auffließen verbessert wird. Bei thermoplastischen Heißschmelzklebemassen ist ein Bereich von 0,01 bis 0,5 MPa bevorzugt, da hierbei die Gefahr des unkontrollierten Masseausfließens verringert ist.

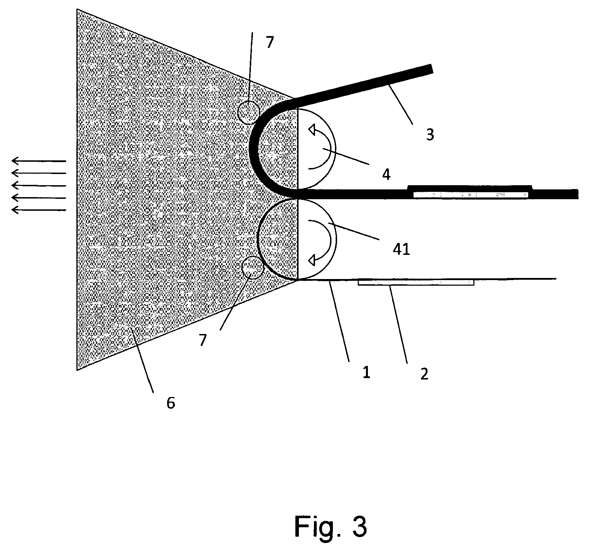

Um auch bei der partiellen Vakuumerzeugung einen möglichst niedrigen Luftdruck zu erreichen, ist es vorteilhaft, eine Vorrichtung zu verwenden, in der Vakuumbox und Laminierwalzen kombiniert sind. Eine solche Vorrichtung ist in Figur 3 beispielhaft gezeigt und wird hiermit als erfinderisch beansprucht.

Die Vorrichtung ist auf bestmögliche Abdichtung hin optimiert. Im Einlauf der auf einem bahnförmigen Substrat 1 zur Verfügung gestellten elektronischen Anordnung 2 sowie des bahnförmigen haft- oder heißschmelzklebrigen Flächengebildes 3 wird die Abdichtung durch mitlaufende Walzen 7 vorgenommen, die ihrerseits im Inneren der Vakuumbox 6 durch berührende Dichtungen oder minimierte Spaltmaße abgedichtet sind. Im Auslauf dient der Laminierspalt zwischen den Laminierwalzen 4 und 41 selbst als Abdichtung.

In einer vorteilhaften Ausführung werden die Dichtungs- und/oder Laminierwalzen aus einem Elastomer gefertigt oder mit einem Elastomerbelag versehen. Dies ermöglicht einen guten Kontakt zu den abzudichtenden Flächen. Bevorzugt weisen die Walzen an ihrer Oberfläche bei Raumtemperatur eine Shore-A-Härte von weniger als 50 auf (DIN 53505 - A, Prüfdauer 3 s). Dies ermöglicht es den Walzenoberfllächen, die Dicke ein- oder auslaufender Flächengebilde elastisch zu kompensieren und auch in den Randbereichen, in denen die Bahn die Walze nicht mehr bedeckt, noch eine ausreichende Abdichtung zu erzielen.

In einer bevorzugten Ausführung weist zumindest eine Walze abhäsive Eigenschaften auf. Dies ist für den Fall der Verwendung einer Haftklebemasse vorteilhaft, damit diese nicht an den sie berührenden Walzen verklebt. Als abhäsives Material kann beispielsweise Silikonelastomer verwendet werden.

Die seitlichen Flächen der Vakuumbox, die die Laminierwalzen 4 und 41 überdecken, sind gegen diese durch minimierte Spaltmaße oder berührende Dichtungen abgedichtet. Hier wie auch bei den Dichtwalzen 7 sind Spaltmaße unter 0,1 mm, insbesondere unterhalb von 0,01 mm vorteilhaft, da damit eine höhere Dichtigkeit erreicht wird. Spaltmaße in diesem Bereich können über sehr enge Fertigungstoleranzen oder die Ausnutzung der unterschiedlichen Längenausdehnung durch eine gezielte, bereichsweise differierende Temperierung der Vorrichtung erreicht werden. Weiterhin können Dichtungen verwendet werden, die durch den äußeren Luftdruck zumindest teilweise geöffnet werden und durch die sich damit einstellende Luftströmung in das Innere der Vakuumbox offen gehalten werden. Solche Dichtungen können zum Beispiel als in das Innere der Vakuumbox gebogene Dichtlippen ausgeführt werden. Abhängig von der Biegesteifigkeit der Dichtlippe bildet sich durch die einströmende Atmosphäre ein mehr oder weniger großer Spalt aus.

Wird die Abdichtung durch berührende Dichtungen ausgeführt, ist es vorteilhaft, wenn die Oberfläche dieser Dichtungen einen niedrigen Reibungskoeffizienten gegenüber dem Walzenmaterial besitzt, damit die Kraft, die benötigt wird, um die Walzen zu drehen möglichst gering gehalten werden kann. Dies ist insbesondere bei der Ausführung der Dichtungen als nach außen gebogene Dichtlippen vorteilhaft, da diese durch den Luftdruck an die Dichtfläche angepresst werden.

Die beschriebenen oder dem Fachmann bekannten Dichtungssysteme können auch in Kombinationen ausgeführt werden.

Als Permeate im Sinne der vorliegenden Schrift werden solche chemischen Substanzen (zum Beispiel Atome, Ionen, Moleküle, ...) bezeichnet, die in eine Anordnung beziehungsweise ein Bauteil, insbesondere eine elektronische oder elektronische Anordnung oder ein entsprechendes Bauteil, eindringen können und hier insbesondere zu Funktionsstörungen führen können. Das Eindringen kann beispielsweise durch das Gehäuse oder die Ummantelung selbst erfolgen, insbesondere aber auch durch Öffnungen im Gehäuse beziehungsweise der Ummantelung oder durch Nahtstellen, Verklebungsstellen, Schweißstellen oder dergleichen. Als Gehäuse beziehungsweise Ummantelung in diesem Sinne werden die Bauteile verstanden, die die empfindlichen Bauteile ganz oder teilweise umschließen und neben ihrer mechanischen Funktion insbesondere zu deren Schutz vorgesehen sind.

Permeate im Sinne der vorliegenden Schrift sind insbesondere niedermolekulare organische oder anorganische Verbindungen, zum Beispiel Wasserstoff ($H_2$), ganz besonders Sauerstoff ($O_2$) und Wasser ($H_2O$). Die Permeate können insbesondere gasförmig oder in Dampfform vorliegen.

Auf die Ausführungen im einführenden Teil dieser Anmeldung wird hiermit Bezug genommen.

Die vorliegende Erfindung beruht zunächst auf der Erkenntnis, dass es trotz der zuvor beschriebenen Nachteile durch das erfindungsgemäße Verfahren dennoch möglich ist, auch eine Haftklebemasse zur Kapselung einer elektronischen Anordnung zu verwenden, bei der die zuvor bezüglich Haftklebemassen beschriebenen Nachteile auftreten. Diese Gruppe der bisher mit Nachteilen versehenen Klebemassen umfasst insbesondere Haft- und Heißschmelzklebemassen, die in chemisch unvernetztem Zustand eine Shear Adhesion Failure Temperature (SAFT) von weniger als 100 °C aufweisen. Dazu gehören vor allem Haftklebemassen auf der Basis von Polyisobutylen (PIB), wie sie beispielsweise in der WO 2007/087281 A1 oder in der DE 10 2008 060 113 A1 beschrieben sind, Blockcopolymeren enthaltend Polymerblöcke überwiegend gebildet von Vinylaromaten (A-Blöcke) und solche überwiegend gebildet durch Polymerisation von 1,3-Dienen (B-Blöcke), und teilkristallinen Polyolefinen, wie sie beispielsweise in der DE 10 2008 047 964 A1 beschrieben sind.

Weiter vorzugsweise wird die elektronische Anordnung auf dem Substrat vollständig von dem Flächengebilde umschlossen, so dass das Flächengebilde zumindest eine Seite, zum Beispiel die Oberseite, sowie die vier Schmalseiten der elektronischen Anordnung bedeckt.

Auf diese Weise entsteht kein Hohlraum zwischen der elektronischen Anordnung und dem Flächengebilde, was beispielsweise einen geringeren Lichtverlust durch unerwünschte Brechung bedeutet. Durch das erfindungsgemäße Verfahren wird es möglich, auch solche Haft- und Heißschmelzklebemassen zu verwenden, die insbesondere bei der vollständigen Umschließung sehr negative optische Defekte im Blasentest zeigen würden.

Bei Verwendung eines die elektronische Anordnung umschließenden Flächengebildes ist es unumgänglich, dieses erst nach der Fertigstellung der elektronischen Anordnung auf dem Substrat zuzulaminieren. Aber auch bei der Verwendung eines als Stanzling zugeführten, den elektronischen Aufbau rahmenförmig umschließenden Flächenelements ist es vorteilhaft, den elektronischen Aufbau zunächst vollständig herzustellen, damit nicht durch zwischen der Lamination und dem Aufbringen einer die Verkapselung final schließenden Abdeckung stattfindende weitere Fertigungsprozesse die Klebemasse geschädigt oder kontaminiert wird, etwa durch eingesetzte Strahlung, Plasmen, thermische Energie oder (chemisch reaktive) Stoffe.

Von besonderem Vorteil für die Kapselung von (opto-)elektronischen Aufbauten ist es, wenn die Haftklebemasse beim erfindungsgemäßen Verfahren während oder nach der Applikation erwärmt wird. Dadurch kann die Haftklebemasse besser auffließen und somit die Permeation an der Grenzfläche zwischen der (opto-)elektronischen Anordnung oder dessen Substrat und der Haftklebemasse vermindert werden. Die Temperatur sollte dabei bevorzugt mehr als 30 °C, weiter bevorzugt mehr als 50 °C betragen, um das Auffließen entsprechend zu fördern. Zu hoch sollte die Temperatur jedoch nicht gewählt werden, um die (opto-)elektronische Anordnung nicht zu beschädigen. Die Temperatur sollte möglichst weniger als 120 °C betragen. Als optimaler Temperaturbereich haben sich Temperaturen zwischen 50 °C und 100 °C herausgestellt. Kann durch entsprechende lokale Erwärmungsverfahren wie zum Beispiel die Ultraschall- oder die Induktionserwärmung die übermäßige Erwärmung der elektronischen Aufbaus vermieden werden, so sind auch höhere Temperaturen, etwa bis 250 °C, vorteilhaft, da bei höheren Temperaturen Vernetzungsreaktionen, zum Beispiel zur Erhöhung der Permeationsbarriere, leichter durchzuführen sind.

In bevorzugter Ausgestaltung eines Verfahrens zur Kapselung einer elektronischen Anordnung gegen Permeate kann die Heißschmelz- oder Haftklebemasse in Form eines Klebebandes bereitgestellt werden. Diese Darreichungsart erlaubt eine besonders einfache und gleichmäßige Applikation der Klebemasse.

Der allgemeine Ausdruck "Flächengebilde" oder "Klebeband" umfasst dabei in einer Ausführungsform ein Trägermaterial, welches ein- oder beidseitig mit einer Haftklebemasse versehen ist. Das Trägermaterial umfasst alle flächigen Gebilde, beispielsweise in zwei Dimensionen ausgedehnte Folien oder Folienabschnitte, Bänder mit ausgedehnter Länge und begrenzter Breite, Bandabschnitte, Stanzlinge. Mehrschichtanordnungen und dergleichen.

Des Weiteren umfasst der Ausdruck "Flächengebilde" oder "Klebeband" auch so genannte "Transferklebebänder", das heißt ein Klebeband ohne Träger. Bei einem Transferklebeband ist zum Beispiel die Haftklebemasse vor der Applikation auf einem oder zwischen flexiblen Linern, die mit einer Trennschicht versehen sind und/oder antiadhäsive Eigenschaften aufweisen, aufgebracht. Zur Applikation wird - falls vorhanden - zunächst der erste Liner entfernt, die Klebemasse appliziert und dann der zweite Liner entfernt. Die Haftklebemasse kann so direkt zur Verbindung zweier Oberflächen in (opto-)elektronischen Anordnungen verwendet werden. Bei einer Heißschmelzklebemasse kann das Transferklebeband zum Beispiel nur die Heißschmelzklebemasse selbst umfassen oder aber auch einen oder zwei zusätzliche Liner.

Dabei sind für verschiedene Anwendungen des Klebebands unterschiedlichste Träger wie zum Beispiel Folien, Gewebe, Vliese und Papiere mit den Klebmassen kombinierbar. Als Trägermaterial eines Klebebandes werden vorliegend bevorzugt Polymerfolien, Folienverbunde oder mit organischen und/oder anorganischen Schichten versehene Folien oder Folienverbunde eingesetzt. Derartige Folien/Folienverbunde können aus allen gängigen zur Folienherstellung verwendeten Kunststoffen bestehen, beispielhaft aber nicht einschränkend erwähnt seien:

Polyethylen, Polypropylen, insbesondere das durch mono-oder biaxiale Streckung erzeugte orientierte Polypropylen (OPP), cyclische Olefin-Copolymere (COC), Polyvinylchlorid (PVC), Polyester, insbesondere Polyethylenterephthalat (PET) und Poylethylennaphtalat (PEN), Ethylenvinylalkohol (EVOH), Polyvinylidenchlorid (PVDC), Polyvinylidenfluorid (PVDF), Polyacrylnitril (PAN), Polycarbonat (PC), Polyamid (PA), Polyethersulfon (PES) oder Polyimid (PI).

Der Träger kann zudem mit organischen oder anorganischen Beschichtungen oder Schichten kombiniert sein. Dies kann durch übliche Verfahren wie zum Beispiel Lackieren, Drucken, Bedampfen, Sputtern, Co-Extrusion oder Lamination geschehen. Beispielhaft, aber nicht einschränkend erwähnt, seien hier etwa Oxide oder Nitride des Siliciums und des Aluminiums, Indium-Zinn-Oxid (ITO) oder Sol-Gel-Beschichtungen.

Besonders bevorzugt sind diese Folien/Folienverbunde, insbesondere die Polymerfolien, mit einer Permeationsbarriere für Sauerstoff und Wasserdampf versehen, wobei die Permeationsbarriere die Anforderungen für den Verpackungsbereich übertrifft (WVTR < $10^{-1}$ g/(m$^2$d); OTR < $10^{-1}$ cm$^3$/(m$^2$d bar)).

Die Bestimmung der Permeabilität für Sauerstoff (OTR) und Wasserdampf (WVTR) erfolgt nach DIN 53380 Teil 3 beziehungsweise ASTM F-1249.

Die Sauerstoffdurchlässigkeit wird bei 23 °C und einer relativen Feuchte von 50 % gemessen. Die Wasserdampfdurchlässigkeit wird bei 37,5 °C und einer relativen Feuchte von 90 % bestimmt. Die Ergebnisse werden auf eine Foliendicke von 50 $\mu$m normiert.

Zudem können die Folien/Folienverbunde in bevorzugter Ausgestaltung transparent ausgebildet sein, damit auch der Gesamtaufbau eines derartigen Klebeartikels transparent ausgebildet ist. "Transparenz" bedeutet dabei eine mittlere Transmission im sichtbaren Bereich des Lichts von mindestens 75 %, bevorzugt höher als 90 %.

Bei der Ausführung als Haftklebeband mit Träger hängt die die maximale Transmission des gesamten Aufbaus zudem von der Art des verwendeten Trägers und der Art des Aufbaus ab.

Je nach Anforderungen der elektronischen Anordnung können in einer bestimmten Ausführung des Verfahrens die elastischen und viskosen Eigenschaften der Heißschmelz- oder Haftklebemasse sowie deren Barrierewirkung auch zusätzlich durch einen nachträglichen Vernetzungsschritt variiert werden. Dies kann angepasst an die elektronische Anordnung sowohl thermisch, als auch durch elektromagnetische Strahlung, bevorzugt aber durch UV-Strahlung, Elektronenstrahlung oder Gammastrahlung stattfinden. Damit kann die Barrierewirkung wie auch die Klebfestigkeit nach dem Einbringen in den elektronischen Aufbau gesteigert werden. Dabei bleibt aber die hohe Flexibilität der Heißschmelz- oder Haftklebemasse im bevorzugten Fall erhalten.

Weiter bevorzugt kommt eine Heißschmelz- oder eine Haftklebemasse zum Einsatz, die in bestimmten Ausführungen im sichtbaren Licht des Spektrums (Wellenlängenbereich von etwa 400 nm bis 800 nm) transparent ist. Für bestimmte Anwendungen, etwa bei Solarzellen kann dieser Bereich aber auch auf definierte UV oder IR-Regionen erweitert werden. Die gewünschte Transparenz im bevorzugten Bereich des sichtbaren Spektrums lässt sich insbesondere durch die Verwendung farbloser Klebharze erzielen. Eine derartige Haftklebemasse eignet sich somit auch für einen vollflächigen Einsatz über einer elektronischen Struktur. Eine vollflächige Verklebung bietet, bei einer etwa mittigen Anordnung der elektronischen Struktur gegenüber einer Randversiegelung den Vorteil, dass der Permeat durch die gesamte Fläche diffundieren müsste, bevor er die Struktur erreicht. Der Permeationsweg ist somit deutlich erhöht. Die in dieser Ausführungsform verlängerten Permeationswege im Vergleich zur Randversiegelung etwa durch Flüssigklebstoffe wirken sich positiv auf die Gesamtbarriere aus, da der Permeationsweg umgekehrt proportional zur Durchlässigkeit ist.

Als Klebemassen finden bevorzugt solche auf Basis von Blockcopolymeren enthaltend Polymerblöcke überwiegend gebildet von Vinylaromaten (A-Blöcke), bevorzugt Styrol, und solche überwiegend gebildet durch Polymerisation von 1,3-Dienen (B-Blöcke), bevorzugt Butadien, Isopren oder einer Mischung aus beiden Monomeren, Verwendung. Diese B-Blöcke weisen üblicherweise eine geringe Polarität auf. Sowohl Homo- als auch Copolymerblöcke sind als B-Blöcke bevorzugt nutzbar.

Die aus den A- und B-Blöcken resultierenden Blockcopolymere können gleiche oder unterschiedliche B-Blöcke enthalten, die teilweise, selektiv oder vollständig hydriert sein können. Die Blockcopolymere können lineare A-B-A-Strukturen aufweisen. Einsetzbar sind ebenfalls Blockcopolymere von radialer Gestalt sowie sternförmige und lineare Multiblockcopolymere. Als weitere Komponenten können A-B-Zweiblockcopolymere vorhanden sein. Blockcopolymere von Vinylaromaten und Isobutylen sind ebenfalls erfindungsgemäß einsetzbar. Sämtliche der vorgenannten Polymere können alleine oder im Gemisch miteinander genutzt werden.

Verwendet werden können auch Blockcopolymere, die neben den oben beschriebenen Blöcken A und B zumindest einen weiteren Block enthalten wie zum Beispiel A-B-C-Blockcoplymere.

Denkbar ist auch die Verwendung der oben genannten B-Blöcke mit A-Blöcken von anderer chemischer Natur, die eine Glasübergangstemperatur oberhalb der Raumtemperatur zeigen, wie zum Beispiel Polymethylmethacrylat.

In einer vorteilhaften Ausführungsform weisen die Blockcopolymere einen Polyvinylaromatenanteil von 10 Gew.-% bis 35 Gew.-% auf.

In einer weiteren bevorzugten Ausgestaltung beträgt der Anteil der Vinylaromatenblockcopolymere in Summe bezogen auf die gesamte Haftklebmasse mindestens 30 Gew.-%, vorzugsweise mindestens 40 Gew.-%, weiter bevorzugt mindestens 45 Gew.-%. Ein zu geringer Anteil an Vinylaromatenblockcopolymere hat zur Folge, dass die Kohäsion der Haftklebmasse relativ niedrig ist. Der maximale Anteil der Vinylaromatenblockcopolymere in Summe bezogen auf die gesamte Haftklebmasse beträgt maximal 80 Gew.-%, bevorzugt maximal 70 Gew.-%. Ein zu hoher Anteil an Vinylaromatenblockcopolymere hat wiederum zur Folge, dass die Haftklebmasse kaum noch haftklebrig ist.

Zumindest ist ein Teil der eingesetzten Blockcopolymere dabei säure- oder säureanhydridmodifiziert, wobei die Modifizierung hauptsächlich durch radikalische Pfropfcopolymerisation von ungesättigten Mono- und Polycarbonsäuren oder -säureanhydriden, wie zum Beispiel Fumarsäure, Itaconsäure, Citraconsäure, Acrylsäure, Maleinsäureanhydrid, Itaconsäureanhydrid oder Citraconsäureanhydrid, bevorzugt Maleinsäureanhydrid erfolgt. Bevorzugt liegt der Anteil an Säure beziehungsweise Säureanhydrid zwischen 0,5 und 4 Gewichtsprozenten bezogen auf das gesamte Blockcopolymer.

Die Vernetzung dieser Elastomere kann auf unterschiedliche Weise erfolgen.

Zum einen können die Säure- beziehungsweise Säureanhydridgruppen mit Vernetzern reagieren, wie zum Beispiel verschiedenen Aminen oder Epoxidharzen.

Als Amine können dabei primäre und sekundäre Amine aber auch Amide und andere stickstoffhaltige Verbindungen wie solche, die ein Wasserstoff direkt am Stickstoff gebunden aufweisen, zum Einsatz kommen.

Als Epoxidharze werden üblicherweise sowohl monomere als auch oligomere Verbindungen mit mehr als einer Epoxidgruppe pro Molekül verstanden. Dieses können Reaktionsprodukte von Glycidestern oder Epichlorhydrin mit Bisphenol A oder Bisphenol F oder Mischungen aus Bisphenol A oder Bisphenol F sein. Einsetzbar sind ebenfalls Epoxidnovolakharze gewonnen durch Reaktion von Epichlorhydrin mit dem Reaktionsprodukt aus Phenolen und Formaldehyd. Auch monomere Verbindungen mit mehreren Epoxidendgruppen, die als Verdünner für Epoxidharze eingesetzt werden sind verwendbar. Ebenfalls sind elastisch modifizierte Epoxidharze einsetzbar oder epoxidmodifizierte Elastomere wie zum Beispiel epoxidierte Styrolblockcopolymere, zum Beispiel Epofriend der Firma Daicel.

Beispiele von Epoxidharzen sind AralditeTM 6010, CY-281TM, ECNTM 1273, ECNTM 1280, MY 720, RD-2 von Ciba Geigy, DERTM 331, 732, 736, DENTM 432 von Dow Chemicals, EponTM 812, 825, 826, 828, 830 etc. von Shell Chemicals, HPTTM 1071, 1079 ebenfalls von Shell Chemicals, BakeliteTM EPR 161, 166, 172, 191, 194 etc. der Bakelite AG.

Kommerzielle aliphatische Epoxidharze sind zum Beispiel Vinylcyclohexandioxide wie ERL-4206, 4221, 4201, 4289 oder 0400 von Union Carbide Corp.

Elastifizierte Elastomere sind erhältlich von der Firma Noveon unter dem Namen Hycar.

Epoxidverdünner, monomere Verbindungen mit mehreren Epoxidgruppen sind zum Beispiel BakeliteTM, EPD KR, EPD Z8, EPD HD, EPD WF, etc. der Bakelite AG oder PolypoxTM R 9, R12, R 15, R 19, R 20 etc. der Firma UCCP.

Üblicherweise wird bei diesen Reaktionen auch ein Beschleuniger eingesetzt. Dieser kann zum Beispiel aus der Gruppe der tertiären Amine oder modifizierten Phosphine, wie zum Beispiel Triphenylphosphin, kommen.

Während die Reaktion mit den Aminen häufig schon bei Raumtemperatur stattfindet, läuft die Vernetzung mit den Epoxidharzen im Allgemeinen unter erhöhter Temperatur ab.

Die zweite Möglichkeit der Vernetzung erfolgt über Metallchelate.

Eine Vernetzung von maleinsäureanhydridmodifizierten Blockcopolymeren mit Metallchelaten ist bekannt aus EP 1 311 559 B1, bei der eine Steigerung der Kohäsion der Blockcopolymermischungen beschrieben wird. Die Verwendung in (opto-)elektronischen Aufbauten ist hingegen nicht erwähnt.

Die Metalle der Metallchelate können die der 2. 3. 4. und 5. Hauptgruppe und die Übergangsmetalle sein. Besonders geeignet sind zum Beispiel Aluminium, Zinn, Titan, Zirkonium, Hafnium, Vanadium, Niob, Chrom, Mangan, Eisen, Kobalt, und Cer. Besonders bevorzugt sind Aluminium und Titan.

Für die Chelatvernetzung können unterschiedliche Metallchelate zum Einsatz kommen, die durch die folgende Formel wiedergegeben werden können:

$$(R_1O)_n \, M \, (XR_2Y)_m,$$

wobei

M ein Metall wie oben beschrieben ist;
$R_1$ eine Alkyl- oder Arylgruppe wie Methyl, Ethyl, Butyl, Isopropyl oder Benzyl ist;
n Null oder eine größere ganze Zahl ist,
X und Y Sauerstoff oder Stickstoff sind, die jeweils auch durch eine Doppelbindung an $R_2$ gebunden sein können;
$R_2$ eine X und Y verbindende Alkylengruppe ist, die verzweigt sein kann, oder auch Sauerstoff oder weitere Heteroatome in der Kette enthalten kann;
m eine ganze Zahl, mindestens jedoch 1 ist,

Bevorzugte Chelatliganden sind solche, die aus der Reaktion folgender Verbindungen entstanden sind: Triethanolamin, 2,4-Pentandion, 2-Ethyl-1,3-Hexandiol oder Milchsäure Besonders bevorzugte Vernetzer sind Aluminium- und Titanylacetylacetonate.

Dabei sollte ein annähernd äquivalentes Verhältnis zwischen den Säurebeziehungsweise Säureanhydridgruppen und den Acetylacetonatgruppen gewählt werden, um eine optimale Vernetzung zu erreichen, wobei sich ein kleiner Überschuss an Vernetzer als positiv herausgestellt hat.

Das Verhältnis zwischen Anhydridgruppen und Acetylacetonatgruppen kann aber variiert werden, dabei sollte für eine ausreichende Vernetzung keine der beiden Gruppen in mehr als einem fünffachen molaren Überschuss vorliegen.

Überraschenderweise zeigen auch Haftklebmassen die mit Chelaten vernetzte mit Säure oder Säureanhydrid modifizierte Vinylaromatenblockcopolymere enthalten eine sehr niedrige Wasserdampf- beziehungsweise Sauerstoff-Durchlässigkeit. Dieses konnte von einer Haftklebemasse mit solch polaren Bestandteilen wie Säureanhydriden und Metallchelaten nicht erwartet werden.

In weiter bevorzugter Ausgestaltung weist die Haftklebemasse neben dem mindestens einen Vinylaromatenblockcopolymer mindestens ein Klebharz auf, um die Adhäsion in gewünschter Weise zu erhöhen. Das Klebharz sollte mit dem Elastomerblock der Blockcopolymere verträglich sein.

Als Klebrigmacher können in der Haftklebemasse zum Beispiel nicht hydrierte, partiell oder vollständig hydrierte Harze auf Basis von Kolophonium und Kolophoniumderivaten, hydrierte Polymerisate des Dicyclopentadiens, nicht hydrierte, partiell, selektiv oder vollständig hydrierte Kohlenwasserstoffharze auf Basis von $C_5$-, $C_5/C_9$- oder $C_9$-Monomerströmen, Polyterpenharze auf Basis von $\alpha$-Pinen und/oder ß-Pinen und/oder δ-Limonen, hydrierte Polymerisate von bevorzugt reinen $C_8$- und $C_9$-Aromaten. Vorgenannte Klebharze können sowohl allein als auch im Gemisch eingesetzt werden. Dabei können sowohl bei Raumtemperatur feste als auch flüssige Harze zum Einsatz kommen. Um eine hohe Alterungs- und UV-Stabilität zu gewährleisten sind hydrierte Harze mit einem Hydrierungsgrad von mindestens 90 %, vorzugsweise von mindestens 95 % bevorzugt.

Des Weiteren sind unpolare Harze mit einem DACP-Wert (diacetone alcohol cloud point) oberhalb von 30 °C und einem MMAP-Wert (mixed methylcylohexane aniline point) von größer 50 °C, insbesondere mit einem DACP-Wert oberhalb von 37 °C und einem MMAP-Wert größer 60 °C bevorzugt. Der DACP-Wert und der MMAP-Wert geben jeweils die Löslichkeit in einem bestimmten Lösemittel an DACP: Lösungsmittelgemisch aus 1:1-Gewichtsteilen Xylol und 4-Hydroxy-4-methyl-2-pentanon; MMAP: Lösungsmittelgemisch aus 1:2-Gewichtsteilen Methylcyclohexan und Anilin). Durch die Auswahl dieser Bereiche wird eine besonders hohe Permeationsbarriere, insbesondere gegen Wasserdampf, erreicht.

Weiter bevorzugt sind Harze mit einer Erweichungstemperatur (Ring/Kugel; Bestimmung nach DIN EN ISO 4625) von mehr als 95 °C, insbesondere mehr als 100 °C. Durch diese Auswahl wird eine besonders hohe Permeationsbarriere, insbesondere gegen Sauerstoff, erreicht.

Unter dem Erweichungspunkt versteht man die Temperatur (beziehungsweise den Temperaturbereich), bei dem Gläser, amorphe oder teilkristalline Polymere vom glasigen, hartelastischen in einen weichen Zustand übergehen. Die Verminderung der Härte entsprechender Stoffe am Erweichungspunkt wird zum Beispiel dadurch deutlich, dass ein auf eine Stoffprobe unter Belastung aufgesetzter Körper bei Erreichen des Erweichungspunktes in diese eingedrückt wird. Der Erweichungspunkt liegt grundsätzlich oberhalb der Glasübergangstemperatur, bei den meisten Polymeren jedoch deutlich unterhalb der Temperatur, bei der diese vollständig in den flüssigen Zustand übergehen.

Wenn eine Erhöhung der Klebkraft erreicht werden soll, sind dagegen insbesondere Harze mit einer Erweichungstemperatur unterhalb von 95 °C, insbesondere unterhalb von 90 °C bevorzugt.

Als weitere Additive können typischerweise genutzt werden:

- Plastifizierungsmittel wie zum Beispiel Weichmacheröle oder niedermolekulare flüssige Polymere wie zum Beispiel niedermolekulare Polybutene
- primäre Antioxidantien wie zum Beispiel sterisch gehinderte Phenole
- sekundäre Antioxidantien wie zum Beispiel Phosphite oder Thioether
- Prozessstabilisatoren wie zum Beispiel C-Radikalfänger
- Lichtschutzmittel wie zum Beispiel UV-Absorber oder sterisch gehinderte Amine
- Verarbeitungshilfsmittel
- Endblockerstärkerharze sowie
- gegebenenfalls weitere Polymere von bevorzugt elastomerer Natur; entsprechend nutzbare Elastomere beinhalten unter anderem solche auf Basis reiner Kohlenwasserstoffe, zum Beispiel ungesättigte Polydiene wie natürliches oder synthetisch erzeugtes Polyisopren oder Polybutadien, chemisch im wesentlichen gesättigte Elastomere wie zum Beispiel gesättigte Ethylen-Propylen-Copolymere, $\alpha$-Olefincopolymere, Polyisobutylen, Butylkautschuk, Ethylen-Propylenkautschuk, sowie chemisch funktionalisierte Kohlenwasserstoffe wie zum Beispiel halogenhaltige, acrylathaltige, allyl- oder vinyletherhaltige Polyolefine.

In einer Ausführungsform der vorliegenden Erfindung enthält die Haftklebemasse auch Füllstoffe, beispielhaft aber nicht einschränkend erwähnt seien Oxide, Hydroxide, Carbonate, Nitride, Halogenide, Carbide oder gemischte Oxid-/ Hydroxid-/Halogenidverbindungen des Aluminiums, Siliciums, Zirkoniums, Titans, Zinns, Zinks, Eisens oder der (Erd)alkalimetalle. Hierbei handelt es sich im Wesentlichen um Tonerden zum Beispiel Aluminiumoxide, Boehmit, Bayerit, Gibbsit, Diaspor und ähnliche. Ganz besonders geeignet sind Schichtsilicate wie beispielsweise Bentonit, Montmorillonit, Hydrotalcit, Hectorit, Kaolinit, Boehmit, Glimmer, Vermiculit oder deren Mischungen. Aber auch Ruße oder weitere Modifikationen des Kohlenstoffs, etwa Kohlenstoffnanoröhrchen können verwendet werden.

Neben den bevorzugten Klebemassen auf der Basis von VinylaromatenBlockcopolymeren können auch dem Fachmann bekannte Klebemassen auf der Basis von Polyisobutylen, Polyolefinen, Polyamiden, Polyestern, Polyurethanen verwendet werden.

Eine weitere Gruppe bevorzugter Klebemasse bilden die hitzeaktivierbaren Klebemassen.

Als die zumindest eine hitzeaktiviert verklebende Klebemasse können grundsätzlich alle üblichen hitzeaktiviert verklebenden Klebemassensysteme zum Einsatz gelangen. Hitzeaktiviert verklebende Klebemassen lassen sich grundsätzlich in zwei Kategorien einordnen: thermoplastische hitzeaktiviert verklebende Klebemassen (Schmelzklebstoffe) und reaktive hitzeaktiviert verklebende Klebemassen (Reaktivklebstoffe). Diese Einteilung enthält auch solche Klebemassen, die sich beiden Kategorien zuordnen lassen, nämlich reaktive thermoplastische hitzeaktiviert verklebende Klebemassen (reaktive Schmelzklebstoffe).

Thermoplastische Klebemassen basieren auf Polymeren, die bei einem Erwärmen reversibel erweichen und während des Erkaltens wieder erstarren. Im Gegensatz dazu enthalten reaktive hitzeaktiviert verklebende Klebemassen reaktive Komponenten. Letztere Bestandteile werden auch als "Reaktivharze" bezeichnet, in denen durch das Erwärmen ein Vernetzungsprozess eingeleitet wird, der nach Beendigen der Vernetzungsreaktion eine dauerhafte stabile Verbindung auch unter Druck gewährleistet. Bevorzugt enthalten derartige thermoplastische Klebemassen auch elastische Komponenten, zum Beispiel synthetische Nitrilkautschuke. Derartige elastische Komponenten verleihen der hitzeaktiviert verklebenden Klebemasse infolge ihrer hohen Fließviskosität eine auch unter Druck besonders hohe Dimensionsstabilität.

Im Folgenden sind rein exemplarisch einige typische Systeme hitzeaktiviert verklebender Klebemassen beschrieben, die sich im Zusammenhang mit der vorliegenden Erfindung als besonders vorteilhaft herausgestellt haben.

Eine thermoplastische hitzeaktiviert verklebende Klebemasse enthält also ein thermoplastisches Basispolymer. Dieses weist bereits bei geringem Anpressdruck ein gutes Fließverhalten auf, so dass sich die für die Haltbarkeit einer dauerhaften Verklebung relevante finale Klebkraft innerhalb kurzer Anpresszeit einstellt und daher ein schnelles Verkleben auch auf rauem oder anderweitig kritischem Untergrund möglich ist. Als thermoplastische hitzeaktiviert verklebende Klebemassen können alle aus dem Stand der Technik bekannten thermoplastischen Klebemassen verwendet werden.

Exemplarische Zusammensetzungen sind etwa in EP 1 475 424 A1 beschrieben. So kann die thermoplastische Klebemasse beispielsweise eine oder mehrere der folgenden Komponenten enthalten oder sogar aus diesen bestehen: Polyolefine, EthylenVinylacetat-Copolymere, Ethylen-Ethylacrylat-Copolymere, Polyamide, Polyester, Polyurethane oder Butadien-Styrol-Blockcopolymere. Weitere thermoplastische Klebemassen, die insbesondere für spezielle Einsatzgebiete wie zum Beispiel das Verkleben von Verklebungssubstraten aus Glas besonders geeignet sind, sind in EP 1 956 063 A2 beschrieben. Bevorzugt werden thermoplastische Klebemassen verwendet, deren Schmelzviskosität durch rheologische Additive heraufgesetzt ist, beispielsweise durch Zusatz von pyrogenen Kieselsäuren, Ruß, Kohlenstoff-Nanoröhren und/oder weiteren Polymeren als Abmischkomponenten.

Eine reaktive hitzeaktiviert verklebende Klebemasse weist hingegen vorteilhafterweise ein elastomeres Basispolymer und ein Modifikationsharz auf, wobei das Modifikationsharz ein Klebharz und/oder ein Reaktivharz umfasst. Infolge der Verwendung eines elastomeren Basispolymers ist es möglich, Klebeschichten mit hervorragender Dimensionsstabilität zu erhalten. Als reaktive hitzeaktiviert verklebende Klebemassen können entsprechend den jeweiligen konkreten Anwendungen alle aus dem Stand der Technik bekannten hitzeaktiviert verklebenden Klebemassen eingesetzt werden.

Dies beinhaltet zum Beispiel auch reaktive hitzeaktiviert verklebende Folien auf Basis von Nitrilkautschuken oder deren Derivaten wie etwa Nitrilbutadienkautschuke oder Mischungen (Blends) dieser Basispolymere, die zusätzlich Reaktivharze wie etwa Phenolharze enthalten; ein derartiges Produkt ist etwa unter der Bezeichnung tesa 8401 kommerziell erhältlich. Der Nitrilkautschuk verleiht der hitzeaktiviert verklebenden Folie infolge seiner hohen Fliessviskosität eine ausgeprägte Dimensionsstabilität, wodurch sich nach Durchführen einer Vernetzungsreaktion hohe Klebkräfte auf Kunststoffoberflächen realisieren lassen.

Natürlich lassen sich auch andere reaktive hitzeaktiviert verklebende Klebemassen einsetzen wie etwa Klebemassen, die zu einem Masseanteil von 50 bis 95 Gew.-% ein verklebbares Polymer und zu einem Masseanteil von 5 bis 50 Gew.-% ein Epoxidharz oder eine Mischung aus mehreren Epoxidharzen enthalten. Das verklebbare Polymer enthält hierbei vorteilhafterweise zu 40 bis 94 Gew.-% Acrylsäureverbindungen und/oder Methacrylsäureverbindungen der allgemeinen Formel $CH_2=C(R^1)(COOR^2)$ ($R^1$ stellt hierbei einen Rest dar, der ausgewählt ist aus der Gruppe umfassend H und $CH_3$, und $R^2$ stellt einen Rest dar, der ausgewählt ist aus der Gruppe umfassend H und lineare oder verzweigte Alkylketten mit 1 bis 30 Kohlenstoffatomen), zu 5 bis 30 Gew.-% ein erstes copolymerisierbares Vinylmonomer, das zumindest eine Säuregruppe aufweist, insbesondere eine Carbonsäuregruppe und/oder Sulfonsäuregruppe und/oder Phosphonsäuregruppe, zu 1 bis 10 Gew.-% ein zweites copolymerisierbares Vinylmonomer, das zumindest eine Epoxidgruppe oder eine Säureanhydridfunktion aufweist, und zu 0 bis 20 Gew.-% ein drittes copolymerisierbares Vinylmonomer, das zumindest eine funktionelle Gruppe aufweist, die sich von der funktionellen Gruppe des ersten copolymerisierbaren Vinylmonomers und von der funktionellen Gruppe des zweiten copolymerisierbaren Vinylmonomers unterscheidet. Eine derartige Klebemasse ermöglicht ein Verkleben mit einer schnellen Aktivierung, bei der innerhalb kurzer Zeit bereits die finale Klebkraft erreicht wird, so dass hierdurch insgesamt eine gut haftende Verbindung auf unpolarem Untergrund gewährleistet ist.

Eine weitere einsetzbare reaktive hitzeaktiviert verklebende Klebemasse, die besondere Vorteile bietet, enthält zu 40 bis 98 Gew.-% ein acrylathaltiges Blockcopolymer, zu 2 bis 50 Gew.-% eine Harzkomponente und zu 0 bis 10 Gew.-% eine Härterkomponente. Die Harzkomponente enthält eines oder mehrere Harze, die gewählt werden aus der Gruppe umfassend die Klebkraft steigernde (klebrigmachende) Epoxidharze, Novolakharze und Phenolharze. Die Härterkomponente wird zum Vernetzen der Harze aus der Harzkomponente eingesetzt. Eine derartige Formulierung bietet infolge der starken physikalischen Vernetzung innerhalb des Polymers den besonderen Vorteil, dass sich Klebeschichten mit einer großen Gesamtdicke erhalten lassen, ohne dass dabei die Belastbarkeit der Verklebung insgesamt beeinträchtigt wird. Dadurch sind diese Klebeschichten besonders geeignet, Unebenheiten im Untergrund auszugleichen. Überdies weist eine solche Klebemasse eine gute Alterungsbeständigkeit und ein nur geringes Ausgasungsverhalten auf, was bei vielen Verklebungen im Elektronikbereich besonders erwünscht ist.

Bevorzugt werden als Füllstoffe der Haftklebmasse nanoskalige und/oder transparente Füllstoffe verwendet. Als nanoskalig wird ein Füllstoff vorliegend bezeichnet, wenn er in mindestens einer Dimension eine maximale Ausdehnung von etwa 100 nm, bevorzugt von etwa 10 nm, aufweist. Besonders bevorzugt werden solche in der Masse transparente Füllstoffe mit plättchenförmiger Kristallitstruktur und einem hohen Aspektverhältnis bei homogener Verteilung verwendet. Die Füllstoffe mit plättchenartiger Kristallitstruktur und Aspektverhältnissen weit über 100 haben in der Regel nur eine Dicke von einigen nm, die Länge beziehungsweise die Breite der Kristallite kann aber bis zu einigen μm betragen. Derartige Füllstoffe werden ebenfalls als Nanopartikel bezeichnet. Die partikuläre Ausgestaltung der Füllstoffe mit kleinen Abmessungen ist zudem besonders vorteilhaft für eine transparente Auslegung der Haftklebemasse.

Durch den Aufbau labyrinthartiger Strukturen mithilfe der zuvor beschriebenen Füllstoffe in der Klebstoffmatrix wird der Diffusionsweg von zum Beispiel Sauerstoff und Wasserdampf derart verlängert, dass ihre Permeation durch die Klebstoffschicht hindurch vermindert wird. Zur besseren Dispergierbarkeit dieser Füllstoffe in der Bindemittelmatrix können diese Füllstoffe mit organischen Verbindungen oberflächlich modifiziert: werden. Der Einsatz derartiger Füllstoffe an sich ist beispielsweise aus der US 2007/0135552 A1 sowie der WO 02/026908 A1 bekannt.

In einer weiteren vorteilhaften Ausführung der vorliegenden Erfindung werden auch Füllstoffe, die mit Sauerstoff und/oder Wasserdampf in besonderer Weise wechselwirken können, eingesetzt. In die (opto-)elektronische Anordnung eindringender Sauerstoff oder Wasserdampf wird dann an diesen Füllstoffen chemisch oder physikalisch gebunden. Diese Füllstoffe werden auch als "getter", "scavenger", "desiccants" oder "absorber" bezeichnet. Solche Füllstoffe umfassen beispielhaft, aber nicht einschränkend: oxidierbare Metalle, Halide, Salze, Silicate, Oxide, Hydroxide, Sulfate, Sulfite, Carbonate von Metallen und Übergangsmetallen, Perchlorate und aktivierten Kohlenstoff, einschließlich seiner Modifikationen. Beispiele sind Cobaltchlorid, Calciumchlorid, Calciumbromid, Lithiumchlorid, Zinkchlorid, Zinkbromid, Siliciumdioxid (Silica Gel), Aluminiumoxid (aktiviertes Aluminium), Calciumsulfat, Kupfersulfat, Natriumdithionit, Natriumcarbonat, Magnesiumcarbonat, Titandioxid, Bentonit, Montmorillonit, Diatomenerde, Zeolithe und Oxide von (Erd)Alkalimetallen, wie Bariumoxid, Calciumoxid, Eisenoxid und Magnesiumoxid oder auch Kohlenstoffnanoröhrchen. Desweiteren können auch organische Absorber eingesetzt werden, beispielsweise Polyolefin-Copolymere, Polyamid-Copolymere, PET-Copolyester oder weitere auf Hybridpolymeren basierende Absorber, die meist in Kombination mit Katalysatoren wie beispielsweise Cobalt verwendet werden. Weitere organische Absorber sind etwa schwach vernetzte Polyacrylsäure, Ascorbate, Glucose, Gallussäure oder ungesättigte Fette und Öle.

Um eine möglichst gute Wirksamkeit der Füllstoffe hinsichtlich der Barrierewirkung zu erzielen, sollte ihr Anteil nicht zu gering sein. Der Anteil beträgt vorzugsweise mindestens 5 Gew.-%, weiter bevorzugt mindestens 10 Gew.-% und ganz bevorzugt mindestens 15 Gew.-%. Typischerweise wird ein möglichst hoher Anteil von Füllstoffen eingesetzt, ohne dabei die Klebkräfte der Haftklebemasse zu stark herabzusetzen oder weitere Eigenschaften zu beeinträchtigen. Der Anteil beträgt daher in einer Auslegung maximal 95 Gew.-%, bevorzugt maximal 70 Gew.-%, weiter bevorzugt maximal 50 Gew.-%.

Des Weiteren ist eine möglichst feine Verteilung und möglichst hohe Oberfläche der Füllstoffe vorteilhaft. Dies ermöglicht einen höheren Wirkungsgrad und eine höhere Beladungskapazität und wird insbesondere mit nanoskaligen Füllstoffen erreicht.

Im Gegensatz zu Laminationen unter Atmosphärendruck zeigen auch nicht vernetzte Klebmassen auf Basis von Vinylaromatenblockcopolymeren oder auch auf Basis von Polyisobutylen bei Verklebung zwischen zwei Polyesterfolien, die zusätzlich eine Barriereschicht besitzen, keine Blasen nach Lagerung bei 85 °C und 85 % r.F.

In einer bevorzugten Ausführung enthält die Heißschmelz- oder Haftklebemasse nicht mehr flüchtige organische Verbindungen (VOC) als 50 $\mu$g Kohlenstoff pro Gramm Masse, insbesondere nicht mehr als 10 $\mu$g C/g, gemessen nach VDA 277. Dies hat den Vorteil besserer Verträglichkeit mit den organischen Materialien des elektronischen Aufbaus sowie mit eventuell vorhandenen Funktionsschichten, wie zum Beispiel einer transparenten leitfähigen Metalloxidschicht, wie zum Beispiel Indium-Zinn-Oxid, oder einer solchen Schicht aus intrinsisch leitfähigem Polymer. Weiterhin kann das Vakuum bei geringer Ausgasung leichter hergestellt werden.

Die Heißschmelz oder Haftklebemasse kann entweder zur vollflächigen Verklebung von elektronischen Anordnungen verwendet werden oder nach entsprechender Konfektionierung können Stanzlinge, Rollen oder sonstige Formkörper aus der Haftklebemasse oder dem Haftklebeband hergestellt werden. Entsprechende Stanzlinge und Formkörper der Haftklebemasse/des Haftklebebandes werden dann vorzugsweise auf das zu verklebende Substrat aufgeklebt, etwa als Umrandungen oder Begrenzung einer elektronischen Anordnung. Die Wahl der Form des Stanzlings oder des Formkörpers ist nicht eingeschränkt und wird abhängig von der Art der elektronischen Anordnung gewählt. Die Möglichkeit der vollflächigen Laminierung ist im Vergleich zu Flüssigklebstoffen durch die Erhöhung der Permeationsweglänge durch seitliches Eindringen der Permeante von vorteil für die Barriereeigenschaften der Masse, da die Permeationsweglänge sich umgekehrt proportional auf die Permeation auswirkt.

Sofern die Klebemasse in Form eines flächigen Gebildes mit einem Träger bereitgestellt wird, ist bevorzugt, dass die Dicke des Trägers bevorzugt im Bereich von etwa 1 $\mu$m bis etwa 350 $\mu$m liegt, weiter bevorzugt zwischen etwa 4 $\mu$m und etwa 250 $\mu$m und besonders bevorzugt zwischen etwa 12 $\mu$m und etwa 150 $\mu$m. Die optimale Dicke hängt von der elektronischen Anordnung, der Endanwendung und der Art der Ausführung der Haftklebemasse ab. Sehr dünne Träger im Bereich von 1 bis 12 $\mu$m werden eingesetzt bei elektronische Aufbauten, die eine geringe Gesamtdicke erreichen sollen, es wird jedoch der Aufwand für die Integration in den Aufbau erhöht. Sehr dicke Träger zwischen 150 und 350 $\mu$m werden eingesetzt wenn eine erhöhte Permeationsbarriere durch den Träger und die Steifigkeit des Aufbaus im Vordergrund stehen; die Schutzwirkung wird durch den Träger erhöht, während die Flexibilität des Aufbaus verringert wird. Der bevorzugte Bereich zwischen 12 und 150 $\mu$m stellt für die meisten elektronischen Aufbauten einen optimalen Kompromiss als Verkapselungslösung dar.

Weitere Einzelheiten, Ziele, Merkmale und Vorteile der vorliegenden Erfindung werden nachfolgend anhand bevorzugter Ausführungsbeispiele näher erläutert. In den Figuren zeigen:

Fig. 1    das erfindungsgemäße Verfahren kommt in einer Vakuumkammer zur Ausführung,

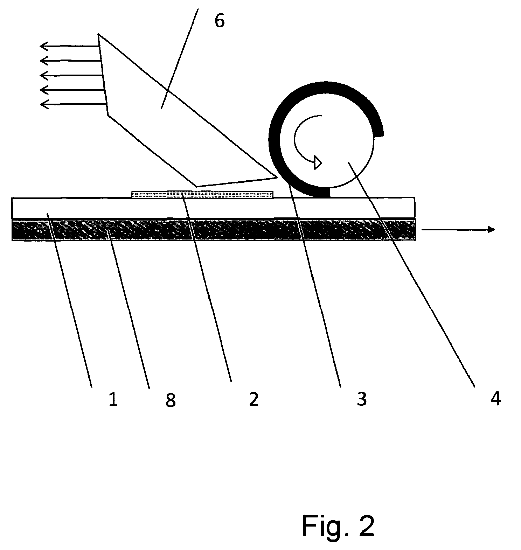

Fig. 2    das erfindungsgemäße Verfahren mit einer partiellen Vakuumerzeugung mittels einer Vakuumbox,

Fig. 3    das erfindungsgemäße Verfahren kommt in einer kontinuierlichen Variante zum Einsatz, wobei das Vakuum partiell mit einer ebenfalls erfindungsgemäßen Vorrichtung erzeugt wird, und

Fig. 4    eine Ausgestaltung einer gekapselten (opto-)elektronischen Anordnung.

Dabei bedeuten:

1 Substrat

2 elektronischer Aufbau

3 Flächengebilde umfassend Heiß- oder Haftschmelzkleber (Klebeband)

4 Laminierwalze

41 zweite Laminierwalze

5 Vakuumkamme

6 Vakuumbox

7 Abdichtwalzen

8 Substrat

9 Abdeckung

21 Glasplatte

22 Klebemasse

23 Calciumspiegel

24 Dünnglasscheibe

25 Transferklebeband

26 PET-Folie

Die Applikation der Klebemasse erfolgt in allen gezeigten Ausführungsbeispielen in Form eines Klebebandes 3. Dabei kann es sich grundsätzlich um ein doppelseitiges Klebeband mit einem Träger oder um ein Transferklebeband handeln. Vorliegend ist eine Ausgestaltung als Transferklebeband gewählt.

Die Dicke der Klebemasse, die entweder als Transferklebeband oder auf einem flächigen Gebilde beschichtet vorliegt, beträgt bevorzugt zwischen etwa 1 $\mu$m und etwa 150 $\mu$m, weiter bevorzugt zwischen etwa 5 $\mu$m und etwa 75 $\mu$m und besonders bevorzugt zwischen etwa 12 $\mu$m und 50 $\mu$m. Hohe Schichtdicken zwischen 50 $\mu$m und 150 $\mu$m werden dann eingesetzt wenn eine verbesserte Haftung auf dem Substrat und/oder eine dämpfende Wirkung innerhalb des elektronischen Aufbaus erreicht werden soll. Nachteilig ist hier jedoch der erhöhte Permeationsquerschnitt. Geringe Schichtdicken zwischen 1 $\mu$m und 12 $\mu$m reduzieren den Permeationsquerschnitt, damit die laterale Permeation und die Gesamtdicke des elektronischen Aufbaus. Jedoch kommt es zu einer Verringerung der Haftung aus dem Substrat. In den besonders bevorzugten Dickenbereichen liegt ein guter Kompromiss zwischen einer geringen Massendicke und dem daraus folgenden niedrigen Permeationsquerschnitt, der die Permeation verringert, und einem genügend dicken Massefilm zur Herstellung einer ausreichend haftenden Verbindung vor. Die optimale Dicke hängt vom elektronischen Aufbau, der Endanwendung, der Art der Ausführung der Klebemasse und gegebenenfalls dem flächigen Substrat ab.

In einer bevorzugten Ausführung des Verfahrens wird die elektronische Anordnung auf einem Substrat vor dem in Kontakt bringen mit dem die Klebemasse umfassenden Flächengebilde im Vakuum selbst hergestellt. Viele Herstellprozesse für Elektronik erfordern Vakuumabscheide- oder Strukturierungsverfahren, um zum Beispiel Elektroden oder elektrisch aktive Schichten abzuscheiden oder zu strukturieren. Beispielhaft sind hier organische Leuchtdioden aus sogenannten Small-Molecules zu nennen. Vorteilhaft ist hier, dass das haftklebrige Flächengebilde nachfolgend, idealerweise in einer geometrisch getrennten Prozesszone, im gleichen Prozessvakuum wie die vorausgehenden Schritte aufgebracht werden kann und somit keine Kontamination oder gar eine funktionale Beeinträchtigung der Oberfläche der elektronischen Anordnung durch zwischenzeitlichen Gaskontakt (zum Beispiel Luft, Schutzgas) stattfinden kann.

In einer bevorzugten Ausführung des Verfahrens wird die elektronische Anordnung auf einem Substrat vor dem in Kontakt bringen mit dem die Klebemasse umfassenden Flächengebilde mit einer Dünnschichtverkapselung versehen. Dieses Verfahren wird in der Regel im Vakuum durchgeführt und wird zum Beispiel von Firmen wie Vitex, USA, angeboten. Vorteilhaft ist hier, dass das haftklebrige Flächengebilde im gleichen Prozessvakuum wie die vorausgehenden Schritte aufgebracht werden kann und somit keine Kontamination der Oberfläche durch zwischenzeitlichen Gaskontakt (zum Beispiel Luft, Schutzgas) stattfinden kann.

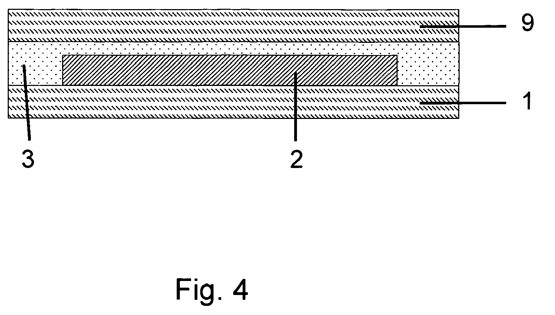

Figur 4 zeigt eine Ausgestaltung einer gekapselten elektronischen Anordnung. Gezeigt ist wiederum eine elektronische Struktur 2, die auf einem Substrat 1 angeordnet und durch das Substrat 1 von unten gekapselt ist. Oberhalb und seitlich von der elektronischen Struktur ist nun die Haftklebemasse 3 vollflächig angeordnet. Die elektronische Struktur 2 wird somit an diesen Stellen durch die Haftklebemasse 3 gekapselt. Auf die Haftklebemasse 3 ist sodann eine Abdeckung 9 aufgebracht. Diese Abdeckung 9 muss nicht zwingend hohe Barriereanforderungen erfüllen, da die Barriere bereits durch die Haftklebemasse 3 bereitgestellt wird. Die Abdeckung 9 kann beispielsweise lediglich eine mechanische Schutzfunktion wahrnehmen, sie kann aber auch zusätzlich als Permeationsbarriere vorgesehen sein.

Im Hinblick auf die Figur 4 wird darauf hingewiesen, dass es sich vorliegend um schematische Darstellungen handelt. Aus den Darstellungen ist insbesondere nicht ersichtlich, dass die Haftklebemasse 3 hier und vorzugsweise jeweils mit einer homogenen Schichtdicke aufgetragen wird. Am Übergang zur elektronischen Struktur bildet sich daher keine scharfe Kante, wie es in der Darstellung scheint, sondern der Übergang ist fließend und es können vielmehr kleine un- oder gasgefüllte Bereiche verbleiben. Gegebenenfalls kann jedoch auch eine Anpassung an den Untergrund erfolgen, insbesondere dann, wenn die Applikation unter Vakuum durchgeführt wird. Zudem wird die Haftklebemasse lokal unterschiedlich stark komprimiert, so dass durch Fließprozesse ein gewisser Ausgleich der Höhendifferenz an den Kantenstrukturen erfolgen kann. Auch die gezeigten Dimensionen sind nicht maßstäblich, sondern dienen vielmehr nur einer besseren Darstellung. Insbesondere die elektronische Struktur selbst ist in der Regel relativ flach ausgebildet (oft weniger als 1 $\mu$m dick).

**Beispiele**

*Permeation*

Die Bestimmung der Permeabilität für Sauerstoff (OTR) und Wasserdampf (WVTR) erfolgte nach DIN 53380 Teil 3 beziehungsweise ASTM F-1249. Die Klebemasse wurde dazu mit einer Schichtdicke von 50 $\mu$m ohne Trägermaterial vermessen. Für die Sauerstoffdurchlässigkeit wurde bei 23 °C und einer relativen Feuchte von 50 % gemessen. Die Wasserdampfdurchlässigkeit wurde bei 37,5 °C und einer relativen Feuchte von 90 % bestimmt.

*Lebensdauertest*

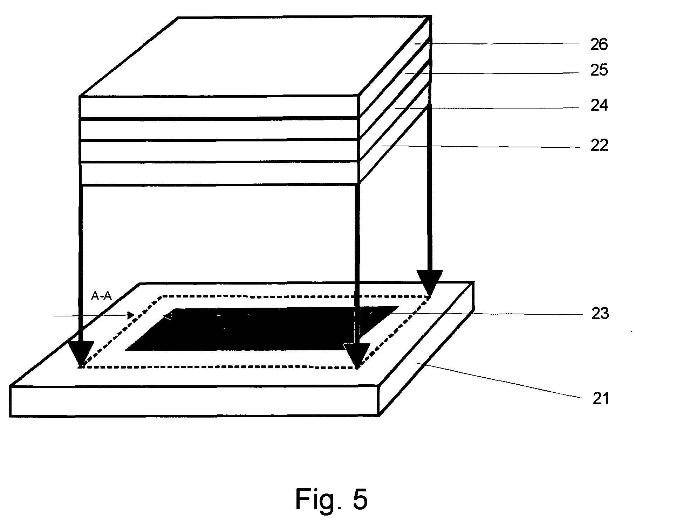

Als ein Maß für die Bestimmung der Lebensdauer eines elektronischen Aufbaus wurde ein Calciumtest herangezogen. Dieser ist in der Figur 5 gezeigt. Dazu wird im Vakuum eine 20 x 20 mm$^2$ große, dünne Calciumschicht 23 auf eine Glasplatte 21 abgeschieden und danach unter Stickstoffatmosphäre gelagert. Die Dicke der Calciumschicht 23 liegt bei etwa 100 nm. Für die Verkapselung der Calciumschicht 23 wird ein Klebeband (26 x 26 mm$^2$) mit der zu testenden Klebemasse 22 sowie einer Dünnglasscheibe 24 (35 $\mu$m, Firma Schott) als Trägermaterial verwendet. Zur Stabilisierung war die Dünnglasscheibe mit einer 100 $\mu$m dicken PET-Folie 26 mittels eines 50 $\mu$m dicken Transferklebebands 25 einer optisch hochtransparenten Acrylathaftklebemasse laminiert. Die Klebemasse 22 wird so auf der Glasplatte 21 appliziert, dass die Klebemasse 22 den Calciumspiegel 23 mit einem allseitig überstehenden Rand von 3 mm (A-A) abdeckt. Aufgrund des undurchlässigen Glasträgers 24 wird nur die Permeation durch den Haftkleber ermittelt. Der Test basiert auf der Reaktion von Calcium mit Wasserdampf und Sauerstoff, wie sie beispielsweise von A.G. Erlat et. al. in "47th Annual Technical Conference Proceedings-Society of Vacuum Coaters", 2004, Seiten 654 bis 659, und von M. E. Gross et al. in "46th Annual Technical Conference Proceedings-Society of Vacuum Coaters", 2003, Seiten 89 bis 92, beschrieben sind. Dabei wird die Lichttransmission der Calciumschicht überwacht, welche durch die Umwandlung in Calciumhydroxid und Calciumoxid zunimmt. Diese erfolgt beim beschriebenen Prüfaufbau vom Rand her, so dass sich die sichtbare Fläche des Calciumspiegels verringert. Es wird die Zeit bis zur Halbierung der Fläche des Calciumspiegels als Lebensdauer bezeichnet. Als Messbedingungen werden 60 °C und 90 % relative Luftfeuchte gewählt. Die Muster wurden mit einer Schichtdicke der Haftklebemasse von 25 $\mu$m vollflächig und blasenfrei verklebt. Der Messwert (in h) ergab sich als Mittelwert aus drei Einzelmessungen.

*Blasentest*

Ein Transfer-Klebeband wird auf eine mit einer anorganischen Barriereschicht versehene PET-Barrierefolie mit einer Dicke von 25 $\mu$m (WVTR = 8x10$^{-2}$ g/m$^2$*d und OTR = 6x10$^{-2}$ cm3/m$^2$*d*bar, entsprechend nach ASTM F-1249 und DIN 53380 Teil 3 und oben genannten Bedingungen) verklebt und bei Raumtemperatur (23 °C) entsprechend dem unten angegebenen Verfahren laminiert. Anschließend wird die zweite Seite der Klebmasse mit derselben Folie ebenfalls wie unten angegeben laminiert, wobei zuvor die silikonisierte PET-Folie entfernt wird. Nach einer Aufziehzeit von 24 h wird das präparierte Muster bei 85 °C und 85 % r.F. für 20 Stunden gelagert. Untersucht wird, ob und wann in dem Verbund Blasen entstehen, sowohl die Anzahl der Blasen pro cm$^2$ als auch deren mittlere Größe wird bestimmt. Es wird die Dauer bis zum Erscheinen erster Blasen vermerkt.

*Klebkraft*

Die Bestimmung der Klebkraft wurde wie folgt durchgeführt: Als definierter Haftgrund wurden eine Stahlfläche, eine Polyesterfläche (PET) und eine Polyethylenfläche (PE) eingesetzt. Das zu untersuchende verklebbare Flächenelement wurde auf eine Breite von 20 mm und eine Länge von etwa 25 cm zugeschnitten, mit einem Handhabungsabschnitt versehen und unmittelbar danach fünfmal mit einer Stahlrolle von 4 kg bei einem Vorschub von 10 m/min auf den jeweils gewählten Haftgrund aufgedrückt. Unmittelbar im Anschluss daran wurde das verklebbare Flächenelement in einem Winkel von 180° vom Haftgrund mit einem Zugprüfgerät (Firma Zwick) abgezogen und die hierfür bei Raumtemperatur benötigte Kraft gemessen. Der Messwert (in N/cm) ergab sich als Mittelwert aus drei Einzelmessungen.

*SAFT - Shear Adhesive Failure Temperature*

Dieser Test dient der Schnellprüfung der Scherfestigkeit von Klebebändern unter Temperaturbelastung. Dafür wird das zu untersuchende Klebeband auf eine temperierbare Stahlplatte geklebt, mit einem Gewicht (50 g) belastet und die Scherstrecke aufgezeichnet.

Messprobenpräparation:

Das zu untersuchende Klebeband wird auf eine 50 μm dicke Aluminiumfolie geklebt. Das so präparierte Klebeband wird auf eine Größe von 10 mm x 50 mm geschnitten. Die zugeschnittene Klebebandprobe wird auf eine polierte, mit Aceton gereinigte Stahl-Prüfplatte (Werkstoff 1.4301, DIN EN 10088-2, Oberfläche 2R, Oberflächen-Rauigkeit $R_a$ 30 bis 60 nm, Abmessungen 50 mm x 13 mm x 1,5 mm) derart verklebt, dass die Verklebungsfläche der Probe Höhe x Breite = 13 mm x 10 mm beträgt und die Stahl-Prüfplatte am oberen Rand um 2 mm überragt. Anschließend mit einer 2 kg-Stahlrolle und einer Geschwindigkeit von 10 m/min zur Fixierung sechsmal überrollt. Die Probe wird oben bündig mit einem stabilen Klebestreifen verstärkt, der als Auflage für den Wegmessfühler dient. Dann wird die Probe mittels der Stahlplatte derart aufgehängt, dass das länger überstehende Ende des Klebebandes senkrecht nach unten zeigt.

*Messung:*

Die zu messende Probe wird am unteren Ende mit einem Gewicht von 50 g belastet. Die Stahl-Prüfplatte mit der verklebten Probe wird beginnend bei 25 °C mit einer Rate von 9 °C pro Minute auf die Endtemperatur von 200 °C aufgeheizt.
Beobachtet wird der Rutschweg der Probe mittels Wegmessfühler in Abhängigkeit von Temperatur und Zeit. Der maximale Rutschweg ist auf 1000 μm (1 mm) festgelegt, bei überschreiten wird der Test abgebrochen und die bis dahin erreichte Temperatur als Testergebnis angegeben. Die relative Luftfeuchtigkeit beträgt 50 ± 5 %.

*Molekulargewichtsbestimmung*

Das gewichtsmittlere Molekulargewicht $M_w$ wird mittels Gelpermeationschromatographie (GPC) bestimmt. Als Eluent wird THF mit 0,1 Vol.-% Trifluoressigsäure eingesetzt. Die Messung erfolgt bei 25 °C. Als Vorsäule wird PSS-SDV, 5 μ, $10^3$ Å, ID 8,0 mm x 50 mm verwendet. Zur Auftrennung werden die Säulen PSS-SDV, 5 μ, $10^3$ sowie $10^5$ und $10^6$ mit jeweils ID 8,0 mm x 300 mm eingesetzt. Die Probenkonzentration beträgt 4 g/l, die Durchflussmenge 1,0 ml pro Minute. Es wird gegen PMMA Standards gemessen. (μ = μm; 1 Å = $10^{-10}$ m).

*Herstellung der Muster*

Die Klebemassen in Beispiel 1 bis 5 wurden aus Lösung hergestellt. Dazu wurden die einzelnen Bestandteile in Toluol gelöst (Feststoffanteil 40 %) und auf eine silikonisierte 50 μm dicke PET-Folie beschichtet und bei 120 °C 15 Minuten lang getrocknet, so dass eine Klebmasseschicht mit einem Flächengewicht von 25 beziehungsweise 50 g/m² entstand.

Haftklebemasse 1

| | |
|---|---|
| 50 Teile | Kraton FG 1924 Maleinsäureanhydridmodifiziertes SEBS mit 13 Gew.-% Blockpolystyrolgehalt, 36 Gew.-% Zweiblock und 1 Gew.-% Maleinsäure der Firma Kraton |
| 50 Teile | Kraton FG 1901 Maleinsäureanhydridmodifiziertes SEBS mit 30 Gew.-% Blockpolystyrolgehalt, ohne Zweiblock und mit 1,7 Gew.-% Maleinsäure der Firma Kraton |
| 70 Teile | Escorez 5615 Hydriertes KW-Harz mit einem Erweichungspunkt von 115 °C der Firma Exxon |
| 25 Teile | Ondina 917 Weißöl aus paraffinischen und naphthenischen Anteilen der Firma Shell |
| 1 Teil | Aluminium-acetylacetonat |

Haftklebemasse 2

| | |
|---|---|
| 100 Teile | Tuftec P 1500 SBBS mit 30 Gew.-% Blockpolystyrolgehalt der Firma Asahi Das SBBS enthält ca. 68 Gew.- |

% Zweiblockgehalt.

| 100 Teile | Escorez 5600 Hydriertes KW-Harz mit einem Erweichungspunkt von 100 °C der Firma Exxon |
| 25 Teile | Ondina 917 Weißöl aus paraffinischen und naphthenischen Anteilen derFirma Shell |

Heißschmelzklebemasse 3

| 100 Teile | Kraton FG 1924 Maleinsäureanhydridmodifiziertes SEBS mit 13 Gew.-% Blockpolystyrolgehalt, 36 Gew.-% Zweiblock und 1 Gew.-% Maleinsäure der Firma Kraton |
| 25 Teile | Escorez 5600 Hydriertes KW-Harz (Kohlenwasserstoffharz) mit einem Erweichungspunkt von 100 °C der Firma Exxon |
| 1 Teil | Aluminium-acetylacetonat |

Haftklebemasse 4

| 100 Teile | SiBStar 103T Triblock-SiBS mit 30 Gew.-% Blockpolystyrolgehalt der Firma Kaneka |
| 40 Teile | SiBStar 042D Diblock-SiB mit 15 Gew.-% Blockpolystyrolgehalt der Firma Kaneka |
| 120 Teile | Escorez 5600 Hydriertes KW-Harz mit einem Erweichungspunkt von 100 °C der Firma Exxon |

Haftklebemasse 5

| 100 Teile | Oppanol B10 Polyisobutylen mit einem mittleren Molekulargewicht $M_w$ von 40.000 g/mol |
| 70 Teile | Oppanol B150 Polyisobutylen mit einem mittleren Molekulargewicht $M_w$ von > 800.000 g/mol |
| 100 Teile | Escorez 5600 Hydriertes KW-Harz mit einem Erweichungspunkt von 100 °C der Firma Exxon |

**Ergebnisse:**

Zur klebtechnischen Beurteilung der oben genannten Beispiele wurden zunächst die Klebkraft und der SAFT-Test durchgeführt.

Tabelle 1

| | Klebkraft [N/cm] Stahl / PET/ PE | SAFT [°C] |
|---|---|---|
| Klebemasse 1 | 5,8 / 4,1 / 3,2 | 200 |
| Klebemasse 2 | 7,3 / 6,2 / 5,7 | 98 |
| Klebemasse 3 | 4,2 / 3,7, | 200 |
| Klebemasse 4 | 5,5 / 4,9 / 4,2 | 94 |
| Klebemasse 5 | 7,5 / 7,0 / 4,9 | 63 |

Wie zu erkennen ist, konnten in allen Beispielen auf allen Untergründen hohe Klebkräfte und bei den beiden Beispielen 1 und 3 exzellente Beständigkeiten bei erhöhten Temperaturen erreicht werden.

Die Ergebnisse der Permeationsmessungen sind in Tabelle 2 zu finden.

Tabelle 2

| | WVTR g/(m$^2$*Tag) | OTR g/ m$^2$*Tag*bar) |
|---|---|---|
| Klebemasse 1 | 22 | 3.120 |
| Klebemasse 2 | 33 | 8.500 |
| Klebemasse 3 | 25 | 5.550 |
| Klebemasse 4 | 8 | 2.100 |
| Klebemasse 5 | 11 | 2.600 |

Wie zu erkennen ist, ist die Sperrwirkung der Klebemassen im Bereich geringer Permeationsraten, was diese Klebemassen besonders für die Verkapselung elektronischer Aufbauten geeignet macht.

**Laminationsversuche**

**Beispiele 1, 2, 4 und 5**

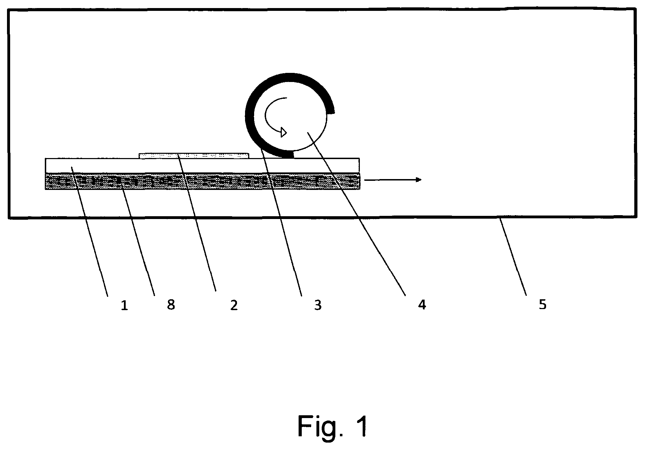

Die Lamination wurde mit einem Verfahren, wie es in Figur 1 dargestellt ist, bei einem Druck von 50 mbar und Raumtemperatur in einer Vakuumkammer ausgeführt. Dazu wurde die in Figur 1 dargestellte Vorrichtung, die eine elastomerummantelte Walze (Shore-A-Härte 40) umfasst, in die Vakuumkammer eingebracht. Ein entsprechend der Prüfmethode hergestelltes und zugeschnittenes Flächengebilde mit der Klebemasse wurde zuvor auf der Laminierwalze befestigt und am Rand in Kontakt mit dem auf dem Substratträger mittels eines doppelseitigen Klebebands befestigten Substrat gebracht. Nachdem das Vakuum hergestellt war, wurde durch eine Drehdurchführung die Laminierwalze gedreht, wobei durch die Haftung der Haftklebemasse am Substrat der Substratträger mitsamt dem Substrat unter der Laminierwalze hindurch gezogen und somit das Laminat bei einer Laminierkraft von 20 N/cm hergestellt wurde.

**Beispiel 3**

Die Lamination wurde bei einer Temperatur von 100 °C in einer Vakuum-Heizpresse der Firma Laufer bei einem Druck von etwa 1 MPa durchgeführt. Das entsprechend der Prüfmethode hergestellte und zugeschnittene heißschmelzklebrige Flächengebilde wurde dabei mittels komprimierbarer Abstandshalter in einem Abstand von ca. 3 mm oberhalb des Substrats angeordnet und erst nach Herstellung des Vakuums mit einem Restdruck von 50 mbar durch Zufahren der Presse in Kontakt mit dem Substrat gebracht. Der Aufbau mit dem Calciumspiegel wurde entsprechend unter Schutzgas hergestellt und in einem durch die Presse verformbaren Behälter in die Vakuumpresse eingebracht. Der Behälter öffnete sich selbsttätig durch den Überdruck des enthaltenen Schutzgases beim Herstellen des äußeren Vakuums. Das Schutzgas wurde dann mit dem Vakuumziehen entfernt. Der Schutzgasbehälter und die Abstandshalter wurden so ausgelegt, dass sie die Lamination nicht hinderten.

**Beispiele 6 bis 9**

Die Lamination wurde mit einem Verfahren, wie es in Figur 3 dargestellt ist, bei einem Druck von 550 mbar in der Vakuumbox und einer Laminierkraft von etwa 40 N/cm ausgeführt (Walzenhärte Shore-A 40). Die in Figur 3 schematisch dargestellte Vorrichtung war zur Herstellung der Muster für den Lebensdauertest in einer mit Stickstoff gefüllten Glovebox aufgestellt, wobei der Abgasstrom der Vakuumpumpe in die Glovebox geleitet wurde um eine Unterdruckbildung dort zu vermeiden. Für die Herstellung von Laminaten für die weiteren Untersuchungen wurde die Vorrichtung an der Luftatmosphäre betrieben. Die Substrate sowie die die Haftklebemasse umfassenden Flächengebilde wurden als Zuschnitte zugeführt.

**Vergleichsbeispiele 1, 2, 4 und 5**

Die Lamination wurde mit der oben beschriebenen Vorrichtung entsprechend Figur 1 bei Raumtemperatur in einer Glovebox unter Stickstoffatmosphäre beziehungsweise an Umgebungsluft und bei Atmosphärendruck (etwa 1,013 bar) durchgeführt. Ein zugeschnittenes Flächengebilde mit der Klebemasse wurde zuvor auf der Laminierwalze befestigt und in Kontakt mit dem auf dem Substratträger mittels eines doppelseitigen Klebebands befestigten Substrat gebracht. Die Laminierwalze wurde gedreht, wobei durch die Haftung der Haftklebemasse am Substrat der Substratträger mitsamt dem Substrat unter der Laminierwalze hindurch gezogen und somit das Laminat bei einer Laminierkraft von 20 N/cm hergestellt wurde.

**Vergleichsbeispiel 3**

Die Lamination wurde bei einer Temperatur von 100 °C in einer Vakuum-Heizpresse der Firma Laufer bei einem Druck von etwa 1 MPa durchgeführt. Das entsprechend der Prüfmethode hergestellte und zugeschnittene heißschmelzklebrige Flächengebilde wurde dabei mittels komprimierbarer Abstandshalter in einem Abstand von ca. 3 mm oberhalb des Substrats angeordnet und durch Zufahren der Presse bei Atmosphärendruck in Kontakt mit dem Substrat gebracht. Der Aufbau mit dem Calciumspiegel wurde entsprechend unter Schutzgas hergestellt und in einem durch die Presse verformbaren Behälter in die Heizpresse eingebracht. Der Behälter öffnete sich selbsttätig durch den Überdruck beim Komprimieren des Behälters beim Zufahren der Presse, so dass sich noch vor dem In-Kontakt-Bringen am Prüfkörper Atmosphärendruck einstellte.

**Ergebnisse des Lebensdauer- und Blasentests:**

Tabelle 3

| | Klebemasse | Laminations verfahren | Lebensdauer [h] | Blasentest [Zeit in h] |
|---|---|---|---|---|
| Beispiel 1 | 1 | Vakuumkammer | 490 | Keine Blasen nach 14 Tagen |
| Beispiel 2 | 2 | Vakuumkammer | 185 | Keine Blasen nach 14 Tagen |
| Beispiel 3 | 3 | Vakuumkammer | 480 | Keine Blasen nach 14 Tagen |
| Beispiel 4 | 4 | Vakuumkammer | 505 | Keine Blasen nach 14 Tagen |
| Beispiel 5 | 5 | Vakuumkammer | 520 | Erste Blasen nach 24 h |
| Beispiel 6 | 1 | Vakuumbox | 375 | Keine Blasen nach 14 Tagen |
| Beispiel 7 | 2 | Vakuumbox | 160 | Keine Blasen nach 14 Tagen |
| Beispiel 8 | 4 | Vakuumbox | 390 | Erste Blasen nach 10 h |
| Beispiel 9 | 5 | Vakuumbox | 410 | Erste Blasen nach 2h |
| Vergleichsbeispiel 1 | 1 | Normaldruck | 350 | Keine Blasen nach 14 Tagen |
| Vergleichsbeispiel 2 | 2 | Normaldruck | 140 | Erste Blasen nach 2h |
| Vergleichsbeispiel 3 | 3 | Normaldruck | 420 | Keine Blasen nach 14 Tagen |
| Vergleichsbeispiel 4 | 4 | Normaldruck | 385 | Erste Blasen nach 2h |
| Vergleichsbeispiel 5 | 5 | Normaldruck | 365 | Erste Blasen nach 1 h |

Die Lebensdauertests zeigen eine signifikante Verlängerung der Lebensdauer durch das erfindungsgemäße Verfahren, wie der jeweilige Vergleich von Beispiel 1 mit Vergleichsbeispiel 1, Beispiel 2 mit Vergleichsbeispiel 2, usw. zeigt. Dies wird auf die verbesserte Benetzung der Oberfläche durch die Klebemasse erklärt. Dadurch werden weniger Mikroblasen eingeschlossen und somit der Permeationsweg an der Grenzfläche dichter.

Im Blasentest zeigt sich eine deutliche Verbesserung. Einige Vergleichsmassen zeigen nun innerhalb von 14 Tagen gar keine Blasenbildung mehr, bei anderen wird die Dauer bis zur ersten Blasenbildung verlängert. Dies wird ebenfalls auf die Verminderung von Mikroblasen an der Grenzfläche zurückgeführt, die als Keime für die weitere Blasenbildung dienen.

**Patentansprüche**

**1.** Verfahren zur Kapselung einer elektronischen Anordnung gegen Permeate, wobei eine elektronische Anordnung auf einem Substrat als bahnförmiges Material zur Verfügung gestellt wird, insbesondere in Form einer Vielzahl von einzelnen elektronischen Anordnungen,
ein haft- oder heißschmelzklebriges Flächengebilde als bahnförmiges Material zur Verfügung gestellt wird, insbesondere als durchgehende Fläche oder einzelne flächige Stanzlinge, die auf einem bahnförmigen Trägersubstrat angeordnet sind,
beide bahnförmigen Materialien über ein Walzenpaar, das zusammen einen Walzenspalt bildet, in eine Vakuumkammer gefahren werden, die durch die Walzen gleichzeitig abgedichtet wird,
beide bahnförmigen Materialien über das Walzenpaar in den Walzenspalt gefahren werden, in dem die Lamination des haft- oder heißschmelzklebrigen Flächengebildes mit der elektronischen Anordnung auf dem Substrat im Vakuum erfolgt,
das entstandene Laminat durch den Walzenspalt der Laminierwalzen aus der Vakuumkammer geführt wird, so dass im Vakuum die den zu kapselnden Bereich der elektronischen Anordnung umfangende Fläche des Substrats, vorzugsweise diese Fläche und der zu kapselnde Bereich der elektronischen Anordnung, mit dem haft- oder heißschmelzklebrigen Flächengebilde in Kontakt gebracht und daraus ein Verbund hergestellt wird.

**2.** Verfahren nach Anspruch 1,
**dadurch gekennzeichnet, dass**
das die Walzen aus einem Elastomer gefertigt oder mit einem Elastomerbelag versehen sind, so dass die Walzen vorzugsweise an ihrer Oberfläche bei Raumtemperatur eine Shore-A-Härte von weniger als 50 aufweisen.

**3.** Verfahren nach Anspruch 1 oder 2,

**dadurch gekennzeichnet, dass**

das Vakuum ein reduzierter Umgebungsdruck von nicht mehr als oder gleich 800 mbar ist, vorzugsweise von weniger als 200 mbar, besonders vorzugsweise von weniger als 50 mbar, ganz besonders vorzugsweise ein Druck zwischen 100 und 200 mbar.

4. Verfahren nach zumindest einem der Ansprüche 1 bis 3,
**dadurch gekennzeichnet, dass**
das Vakuum, in dem das Flächengebilde auf die elektronische Anordnung laminiert wird, partiell auf der elektronischen Anordnung und/oder dem Substrat hergestellt wird.

5. Verfahren nach Anspruch 4,
**dadurch gekennzeichnet, dass**
das Vakuum in einem Spalt zwischen zwei Walzen mittels eines Vakuumschachts erzeugt wird, in dem die Lamination stattfindet,

6. Verfahren nach zumindest einem der vorherigen Ansprüche,
**dadurch gekennzeichnet, dass**
das Verfahren mit weiteren Vakuumverfahren kombiniert wird, die zum Herstellen von elektronischen Aufbauten verwendet werden.

7. Verfahren nach zumindest einem der vorherigen Ansprüche,
**dadurch gekennzeichnet, dass**
die elektronische Anordnung vor dem Inkontaktbringen mit einer Dünnschichtverkapselung versehen wird.

8. Verfahren nach zumindest einem der vorherigen Ansprüche,
**dadurch gekennzeichnet, dass**
das Vakuum durch Erhöhung der geographischen Höhe des Laminationsortes erzeugt wird.

## Claims

1. Method for encapsulating an electronic arrangement against permeates,
wherein an electronic arrangement is provided on a substrate as a web material, more particularly in the form of a multiplicity of individual electronic arrangements,
a pressure-sensitively adhesive or hotmelt-adhesive sheetlike structure is provided as a web material, more particularly as a continuous area or individual sheetlike diecuts disposed on a carrier substrate in web form,
the two web materials are passed into a vacuum chamber via a pair of rolls together forming a roll nip, said chamber being sealed off at the same time by the rolls, the two web materials are passed into the roll nip via the pair of rolls, and the lamination of the pressure-sensitively adhesive or hotmelt-adhesive sheetlike structure with the electronic arrangement on the substrate takes place in a vacuum in said roll nip,
the resultant laminate is led from the vacuum chamber through the roll nip of the laminating rolls, so that in a vacuum the area of the substrate including the region of the electronic arrangement that is to be encapsulated, preferably this area and the region of the electronic arrangement that is to be encapsulated, is contacted with the pressure-sensitively adhesive or hotmelt-adhesive sheetlike structure, and an assembly is produced therefrom.

2. Method according to Claim 1,
**characterized in that**
the rolls are manufactured from an elastomer or are provided with an elastomer covering, and so the rolls on their surface at room temperature have a Shore A hardness of preferably less than 50.

3. Method according to Claim 1 or 2,
**characterized in that**
the vacuum is a reduced ambient pressure of not more than or equal to 800 mbar, preferably of less than 200 mbar, more preferably of less than 50 mbar, very preferably a pressure of between 100 and 200 mbar.

4. Method according to at least one of Claims 1 to 3,
**characterized in that**
the vacuum in which the sheetlike structure is laminated onto the electronic arrangement is produced partially on the electronic arrangement and/or on the substrate.

5. Method according to Claim 4,
**characterized in that**
the vacuum is generated in a nip between two rolls by means of a vacuum shaft, in which the lamination takes place.

6. Method according to at least one of the preceding claims,
**characterized in that**
the method is combined with other vacuum techniques which are used for producing electronic assemblies.

7. Method according to at least one of the preceding claims,
**characterized in that**
the electronic arrangement is provided with a thin-film encapsulation prior to the contacting.

8. Method according to at least one of the preceding claims,
**characterized in that**
the vacuum is generated by raising the geographical height of the site of lamination.

**Revendications**

1. Procédé d'encapsulation d'un agencement électronique contre des perméats, selon lequel un agencement électronique sur un substrat en tant que matériau en forme de bande est mis à disposition, notamment sous la forme d'une pluralité d'agencements électroniques individuels,
une structure plate adhésive par contact ou thermofusible en tant que matériau en forme de bande est mise à disposition, notamment en tant que surface continue ou formes prédécoupées plates individuelles, qui sont agencées sur un substrat support en forme de bande,
les deux matériaux en forme de bande sont conduits par une paire de cylindres, qui forment ensemble un espace entre les cylindres, dans une chambre sous vide, qui est étanchéifié simultanément par les cylindres,
les deux matériaux en forme de bande sont conduits par la paire de cylindres dans l'espace entre les cylindres, dans lequel la stratification de la structure plate adhésive par contact ou thermofusible avec l'agencement électronique sur le substrat a lieu sous vide,
le stratifié formé est déchargé de la chambre sous vide par l'espace entre les cylindres des cylindres de stratification, de sorte que
la surface du substrat entourant la zone à encapsuler de l'agencement électronique, de préférence cette surface et la zone à encapsuler de l'agencement électronique, est mise en contact sous vide avec la structure plate adhésive par contact ou thermofusible et un composite est fabriqué à partir de celles-ci.

2. Procédé selon la revendication 1, **caractérisé en ce que** les cylindres sont en un élastomère ou sont munis d'un revêtement élastomère, de sorte que les cylindres présentent de préférence sur leur surface à température ambiante une dureté Shore A de moins 50.

3. Procédé selon la revendication 1 ou 2, **caractérisé en ce que** le vide est une pression ambiante réduite inférieure ou égale à 800 mbar, de préférence inférieure à 200 mbar, de manière particulièrement préférée inférieure à 50 mbar, de manière tout particulièrement préférée une pression comprise entre 100 et 200 mbar.

4. Procédé selon au moins l'une quelconque des revendications 1 à 3, **caractérisé en ce que** le vide dans lequel la structure plate est stratifiée sur l'agencement électronique est généré en partie sur l'agencement électronique et/ou le substrat.

5. Procédé selon la revendication 4, **caractérisé en ce que** le vide dans un espace entre deux cylindres est généré au moyen d'un puits sous vide, dans lequel la stratification a lieu.

6. Procédé selon au moins l'une quelconque des revendications précédentes, **caractérisé en ce que** le procédé est combiné avec d'autres procédés sous vide qui sont utilisés pour la fabrication de structures électroniques.

7. Procédé selon au moins l'une quelconque des revendications précédentes, **caractérisé en ce que** l'agencement électronique est muni d'une encapsulation à couche mince avant la mise en contact.

8. Procédé selon au moins l'une quelconque des revendications précédentes, **caractérisé en ce que** le vide est généré par augmentation de la hauteur géographique du lieu de stratification.

Fig. 1

Fig. 2

Fig. 3

Fig. 4

26
25
24
22
23
21

A-A

Fig. 5

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 9821287 A1
- US 4051195 A
- US 4552604 A
- US 20040225025 A1
- US 20060100299 A1
- WO 2007087281 A1
- DE 102008047964 A1
- WO 03065470 A1

- EP 2166593 A1
- US 5904488 A
- DE 102008060113 A1
- EP 1311559 B1
- EP 1475424 A1
- EP 1956063 A2
- US 20070135552 A1
- WO 02026908 A1


**In der Beschreibung aufgeführte Nicht-Patentliteratur**

- **VON HELMUT GREIF.** Technologie der Extrusion. Carl Hanser Verlag, 2004
- **VON A.G. ERLAT.** *47th Annual Technical Conference Proceedings-Society of Vacuum Coaters,* 2004, 654-659

- **VON M. E. GROSS et al.** *46th Annual Technical Conference Proceedings-Society of Vacuum Coaters,* 2003, 89-92